# EUROPEAN PATENT APPLICATION

(11) **EP 4 823 270 A1**
(43) Date of publication of application: **14.10.2026**
(21) Application number: 26166230.8
(22) Date of filing: 19.03.2026
(51) Int. Cl.: H10B 80/00, G11C 5/14, G11C 16/30, H10B 43/27, H10B 43/40, H10D 1/68, H10D 80/20, H10W 80/00

(54) **SEMICONDUCTOR DEVICE AND DATA STORAGE SYSTEM INCLUDING THE SAME**

(30) Priority: 11.04.2025 KR 20250047691
(71) Applicant: Samsung Electronics Co., Ltd., Suwon-si, Gyeonggi-do 16677 (KR)
(72) Inventor: NAM, Seungwoo, 16677 Suwon-si (KR); JUNG, Hanbit, 16677 Suwon-si (KR); KANG, Shinhwan, 16677 Suwon-si (KR); SON, Younghwan, 16677 Suwon-si (KR); SUNG, Sukkang, 16677 Suwon-si (KR)
(74) Representative: Marks & Clerk LLP

(57) **Abstract**

In the semiconductor device according to the inventive concept, part of a multi-layer wiring structure (ML) located in a wiring region (MA) of a peripheral circuit structure (PERI) may be replaced by a replacement process to form a capacitor structure (CS), and thus, there is the effect of improving electrical characteristics and reliability due to an increase in the area of the capacitor structure.

## Description

### BACKGROUND

The inventive concept relates to a semiconductor device and a data storage system including the same, and more particularly, to a semiconductor device including a capacitor structure and a data storage system including the semiconductor device.

In order to achieve excellent performance and economic efficiency, there is a need to increase the degree of integration of semiconductor devices. In particular, the degree of integration of memory devices is an important factor in determining the economic efficiency of products. The degree of integration of a two-dimensional memory device is mainly determined by the area occupied by a unit memory cell and is thus significantly affected by the level of fine pattern formation technology. However, expensive equipment is required to form fine patterns, and the area of chip dies is limited. Therefore, although the degree of integration of two-dimensional memory devices is increasing, the increase in degree of integration is still limited. Accordingly, there are needs for technology capable of increasing the degree of integration of two-dimensional memory devices and technology for vertical memory devices having three-dimensional structures.

### SUMMARY

The inventive concept provides a semiconductor device having improved electrical characteristics and reliability due to an increase in the area of a capacitor structure, and a data storage system including the semiconductor device.

The objectives of the inventive concept are not limited to those stated above, and other objectives not described herein will be clearly understood by those skilled in the art from the following description.

According to an aspect of the inventive concept, there is provided a semiconductor device including a peripheral circuit structure including a substrate having an active region defined by a device isolation region, a peripheral circuit device on the active region, a multi-layer wiring structure connected to the peripheral circuit device, a multi-layer insulating structure surrounding the multi-layer wiring structure, a capacitor structure spaced apart from the multi-layer wiring structure in a horizontal direction and at least partially extending through the multi-layer insulating structure, and first bonding pads connected to the multi-layer wiring structure and the capacitor structure, and a memory cell structure including a passivation layer having a cell region and a pad region, gate electrodes stacked in the cell region and spaced apart from each other in a vertical direction, a channel structure extending through the gate electrodes, an input/output pad located in the pad region, a cover insulating layer covering the cell region and the pad region, a through-plug extending through the cover insulating layer in the pad region and connected to the input/output pad, a cell wiring structure connected to the channel structure and the through-plug, and second bonding pads connected to the cell wiring structure, in which the capacitor structure includes a first electrode layer conformally formed on an inner wall of a recess region at least partially extending through the multi-layer insulating structure, a capacitor dielectric layer conformally formed on an inner wall of the first electrode layer, and a second electrode layer in contact with an inner wall of the capacitor dielectric layer and filling the recess region, and at least a part of a first routing via which is in contact with an upper surface of the first electrode layer, is positioned at substantially a same vertical level as at least a part of a second routing via in contact with an upper surface of the second electrode layer.

According to an embodiment there is provided a semiconductor device comprising: a peripheral circuit structure comprising a substrate having an active region defined by a device isolation region, a peripheral circuit device on the active region, a multi-layer wiring structure connected to the peripheral circuit device, a multi-layer insulating structure surrounding the multi-layer wiring structure, a capacitor structure spaced apart from the multi-layer wiring structure in a horizontal direction and at least partially extending through the multi-layer insulating structure, and first bonding pads connected to the multi-layer wiring structure (ML) and the capacitor structure; and a memory cell structure comprising a passivation layer having a cell region and a pad region, gate electrodes stacked in the cell region and spaced apart from each other in a vertical direction, a channel structure extending through the gate electrodes, an input/output pad located in the pad region, a cover insulating layer covering the cell region and the pad region, a through-plug extending through the cover insulating layer in the pad region and connected to the input/output pad, a cell wiring structure connected to the channel structure and the through-plug, and second bonding pads connected to the cell wiring structure. The capacitor structure comprises a first electrode layer conformally formed on an inner wall of a recess region at least partially extending through the multi-layer insulating structure, a capacitor dielectric layer conformally formed on an inner wall of the first electrode layer, and a second electrode layer in contact with an inner wall of the capacitor dielectric layer and filling the recess region. The peripheral circuit structure further comprises a first routing via which is in contact with an upper surface of the first electrode layer and a second routing via which is in contact with an upper surface of the second electrode layer, wherein at least a part of the first routing via is positioned at substantially a same vertical level as at least a part of the second routing via.

According to another aspect of the inventive concept, there is provided a semiconductor device including a substrate having an active region defined by a device isolation region, a peripheral circuit device on the active region, a multi-layer wiring structure including a plurality of wiring layers connected to the peripheral circuit device and a plurality of via layers connecting the plurality of wiring layers to each other in a vertical direction, a multi-layer insulating structure including a plurality of insulating layers surrounding the plurality of wiring layers and the plurality of via layers, a recess region including a plurality of recess patterns spaced apart from the multi-layer wiring structure in a horizontal direction and at least partially extending through the multi-layer insulating structure, a first electrode layer conformally arranged along inner walls of the plurality of recess patterns and an upper surface of the multi-layer insulating structure, a capacitor dielectric layer conformally arranged along an inner wall and an upper surface of the first electrode layer, a second electrode layer in contact with an inner wall and an upper surface of the capacitor dielectric layer and filling the plurality of recess patterns, a first routing via in contact with the upper surface of the first electrode layer, and a second routing via in contact with an upper surface of the second electrode layer, in which a sidewall of the first electrode layer located in each of the plurality of recess patterns has a plurality of curved sections in the vertical direction.

According to another aspect of the inventive concept, there is provided a data storage system including a main board, a semiconductor device on the main board, and a controller provided on the main board and electrically connected to the semiconductor device, in which the semiconductor device includes a peripheral circuit structure and a memory cell structure disposed on the peripheral circuit structure, the peripheral circuit structure includes a substrate having an active region defined by a device isolation region, a peripheral circuit device on the active region, a multi-layer wiring structure connected to the peripheral circuit device, a multi-layer insulating structure surrounding the multi-layer wiring structure, a capacitor structure spaced apart from the multi-layer wiring structure in a horizontal direction and at least partially extending through the multi-layer insulating structure, and first bonding pads connected to the multi-layer wiring structure and the capacitor structure, the memory cell structure includes a passivation layer having a cell region and a pad region, gate electrodes stacked in the cell region and spaced apart from each other in a vertical direction, a channel structure extending through the gate electrodes, an input/output pad located in the pad region, a cover insulating layer covering the cell region and the pad region, a through-plug extending through the cover insulating layer in the pad region and connected to the input/output pad, a cell wiring structure connected to the channel structure and the through-plug, and second bonding pads connected to the cell wiring structure, the capacitor structure includes a first electrode layer conformally formed on an inner wall of a recess region at least partially extending through the multi-layer insulating structure, a capacitor dielectric layer conformally formed on an inner wall of the first electrode layer, and a second electrode layer in contact with an inner wall of the capacitor dielectric layer and filling the recess region, at least a part of a first routing via, which is in contact with an upper surface of the first electrode layer, is positioned at substantially a same vertical level as at least a part of a second routing via in contact with an upper surface of the second electrode layer, and the first bonding pads are respectively bonded to the second bonding pads.

According to another aspect of the inventive concept, there is provided a semiconductor device manufacturing method including preparing a substrate that includes a first region and a second region surrounding the first region, sequentially forming a plurality of wiring layers and a plurality of via layers, which are alternately arranged in the first and second regions in a vertical direction, and a plurality of insulating layers, which surround the wiring layers and the via layers, removing the plurality of wiring layers and the plurality of via layers from the first region, forming a plurality of recess patterns by expanding a space of the first region from which the plurality of wiring layers and the plurality of via layers have been removed, forming a first electrode layer that conformally covers the inner walls of the plurality of recess patterns and the upper surfaces of the plurality of insulating layers, forming a capacitor dielectric layer that conformally covers the inner wall and upper surface of the first electrode layer, forming a second electrode layer that is in contact with the inner wall and upper surface of the capacitor dielectric layer and fills the plurality of recess patterns, and forming a first routing via in contact with the upper surface of the first electrode layer and a second routing via in contact with the upper surface of the second electrode layer.

In embodiments, in the forming of the first and second routing vias, an uppermost end of the first routing via may be positioned at substantially a same vertical level as an uppermost end of the second routing via, and a lowermost end of the first routing via may be positioned at a lower vertical level than a lowermost end of the second routing via.

In embodiments, in the forming of the plurality of recess patterns, uppermost ends of some of the plurality of recess patterns arranged below a region in which the first routing via is to be formed may be lower than uppermost ends of the other recess patterns.

In embodiments, in the forming of the plurality of recess patterns, a sidewall of each of the plurality of recess patterns may have a plurality of curved sections in the vertical direction, and vertical levels of the plurality of curved sections in the first region may be substantially the same as vertical levels of bonding interfaces between the plurality of wiring layers and the plurality of via layers in the second region.

In embodiments, in the forming of the plurality of recess patterns, at least some of the plurality of curved sections may have a rounded shape by cleaning and wet etching processes.

In embodiments, the semiconductor device manufacturing method may further include manufacturing a peripheral circuit structure by forming first bonding pads connected to the first and second routing vias and manufacturing a memory cell structure, in which the memory cell structure includes a passivation layer having a cell region and a pad region, gate electrodes stacked in the cell region and spaced apart from each other in a vertical direction, a channel structure extending through the gate electrodes, an input/output pad located in the pad region, a cover insulating layer covering the cell region and the pad region, a through-plug extending through the cover insulating layer in the pad region and connected to the input/output pad, a cell wiring structure connected to the channel structure and the through-plug, and second bonding pads connected to the cell wiring structure.

In embodiments, the semiconductor device manufacturing method may further include bonding the first bonding pads of the peripheral circuit structure to the second bonding pads of the memory cell structure.

In embodiments, the first bonding pads may be bonded to the second bonding pads by metal-to-metal bonding.

In embodiments, the first electrode layer, the capacitor dielectric layer, and the second electrode layer may overlap the pad region in the vertical direction but may not overlap the cell region in the vertical direction.

In embodiments, the first and second routing vias each may be electrically connected to the input/output pad via the first bonding pad, the second bonding pad, and the through-plug.

At least some of the above and other features of the invention are set out in the claims.

### BRIEF DESCRIPTION OF THE DRAWINGS

Embodiments will be more clearly understood from the following detailed description taken in conjunction with the accompanying drawings in which:
FIG. 1 is a block diagram showing a semiconductor device according to an embodiment;
FIG. 2 is a circuit diagram showing a charge pump circuit in a voltage generator of the semiconductor device of FIG. 1;
FIG. 3 is a perspective view schematically showing a semiconductor device according to an embodiment;
FIG. 4 is a plan view showing components of a semiconductor device according to an embodiment;
FIG. 5 is a cross-sectional view of a semiconductor device taken along line CX-CX' of FIG. 4;
FIG. 6 is a plan view showing a capacitor structure of a semiconductor device, according to an embodiment, with respect to a first level LV1, a second level LV2, and third level LV3;
FIG. 7 is a cross-sectional view of the capacitor structure taken along lines CX1, CX2, and CX3 of FIG. 6;
FIG. 8 is a cross-sectional view showing a comparison between a wiring region and a partial region of FIG. 7;
FIG. 9 is an enlarged view of region BB of FIG. 7;
FIG. 10 is an enlarged view of region CC of FIG. 7;
FIG. 11 is an enlarged view of region DD of FIG. 7;
FIG. 12 is an enlarged view of region EE of FIG. 7;
FIGS. 13 through 15 are cross-sectional views showing semiconductor devices according to some embodiments;
FIG. 16 is a flowchart showing a semiconductor device manufacturing method according to an embodiment;
FIGS. 17 through 27 are cross-sectional views showing, in a process sequence, a semiconductor device manufacturing method according to an embodiment;
FIG. 28 is a diagram illustrating a data storage system including a semiconductor device according to an embodiment;
FIG. 29 is a perspective view showing a data storage system including a semiconductor device according to an embodiment; and
FIG. 30 is a cross-sectional view showing a semiconductor package including a semiconductor device according to an embodiment.

### DETAILED DESCRIPTION OF THE EMBODIMENTS

Hereinafter, an embodiment is described in detail with reference to the accompanying drawings.

As used herein, the singular forms "a", "an", and "the" are intended to include the plural forms as well, unless the context clearly indicates otherwise. Additionally, the description may be specific to a portion of the semiconductor device and the described structure may be repeated in other portions of the semiconductor device. For example, the described structure may be an individual element of an array of elements forming the semiconductor device. Accordingly, where the structure of a single element of a plurality of elements has been described, this structure may equally apply to other elements of the plurality of elements.

The terms "upper", "middle", "lower" may refer to relative positions along a particular direction (e.g. a vertical direction). Various directions (e.g. vertical direction, horizontal direction, etc.) may be defined relative to the structure of the devices described herein. It will be appreciated that these directions do not necessarily imply any particular orientation of the device in use.

The term "overlap" (or "overlapping", or like terms), as may be used herein, is intended to broadly refer to a first element that intersects with at least a portion of a second element when viewed in a particular direction (e.g., in a vertical direction), but does not require that the first and second elements be completely aligned with one another. Components or layers described with reference to "overlap" in a particular direction may be at least partially obstructed by one another when viewed along a line extending in the particular direction. For instance, components or layers described with reference to "overlap" in a particular direction may be positioned such that a line that runs parallel to the particular direction may be positioned such that it intersects at least a portion of each of the components or layers.

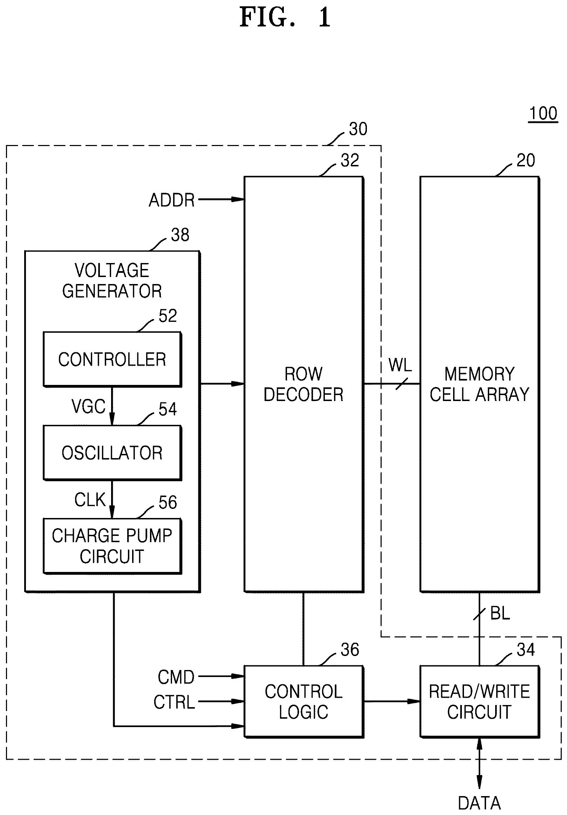

FIG. 1 is a block diagram showing a semiconductor device 100 according to an embodiment.

Referring to FIG. 1, the semiconductor device 100 may include a memory cell array 20 and a peripheral circuit 30, and the semiconductor device 100 may represent a non-volatile memory device such as flash memory.

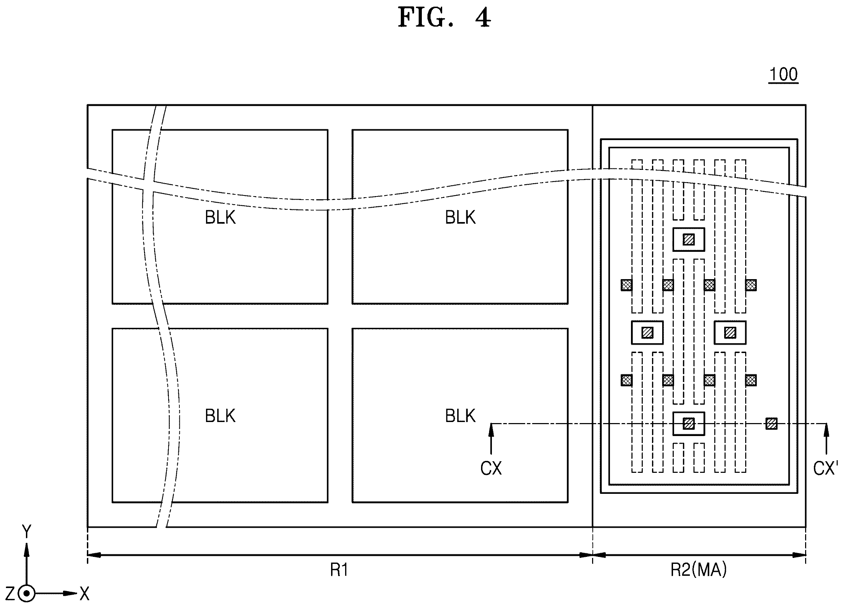

The memory cell array 20 may include a plurality of memory cells. In some embodiments, the memory cell array 20 may include a plurality of memory blocks BLK (see FIG. 4), and each of the memory blocks BLK (see FIG. 4) may include a plurality of memory cells. Here, the plurality of memory cells may be connected to a row decoder 32 via a plurality of word lines WL and may be connected to a read/write circuit 34 via a plurality of bit lines BL. A plurality of memory cells arranged along the same row may be connected to the same word line WL, and a plurality of memory cells arranged along the same column may be connected to the same bit line BL.

The peripheral circuit 30 may receive an address ADDR, a command CMD, and a control signal CTRL from the outside of the semiconductor device 100 and may transmit data DATA to or receive the data DATA from a device outside of the semiconductor device 100. The peripheral circuit 30 may include the row decoder 32, the read/write circuit 34, a control logic 36, and a voltage generator 38 that generates various voltages necessary for operation. In some embodiments, the peripheral circuit 30 may further include various subcircuits, such as an input/output circuit and an error correction circuit for correcting errors in the data DATA read from the memory cell array 20.

The row decoder 32 may select some of the plurality of memory cells in response to the address ADDR and may select at least one word line WL. The row decoder 32 may transmit a voltage for performing a memory operation to the selected word line WL.

The read/write circuit 34 may be connected to the memory cell array 20 via the bit line BL. The read/write circuit 34 may include a write driver or a sense amplifier. Specifically, during a read operation, the read/write circuit 34 may operate as a sense amplifier and sense the data DATA stored in the memory cell array 20. In addition, during a write operation, the read/write circuit 34 may operate as a write driver and apply, to the bit line BL, a voltage according to the data DATA that is to be stored in the memory cell array 20.

The control logic 36 may be connected to the row decoder 32, the voltage generator 38, and the input/output circuit. The control logic 36 may control all operations of the semiconductor device 100. In response to the control signal CTRL, the control logic 36 may generate various internal control signals that are used in the semiconductor device 100. For example, the control logic 36 may adjust a voltage level provided to the word line WL and the bit line BL, when performing memory operations, such as a program operation and an erase operation.

The voltage generator 38 may include a controller 52, an oscillator 54, and a charge pump circuit 56.

The controller 52 may control an operation of the oscillator 54. For example, the controller 52 may determine the frequency of a clock signal CLK, which is output to the charge pump circuit 56 by the oscillator 54, based on at least one of process, voltage, or temperature (PVT) information of the semiconductor device 100 and a target level of the voltage to be output by the charge pump circuit 56. In some embodiments, when the charge pump circuit 56 includes a plurality of charge pumps, a charge pump that actually operates among the plurality of charge pumps may be determined by the controller 52.

The oscillator 54 may output the clock signal CLK that turns on and turns off a switch element included in the charge pump circuit 56. The clock signal CLK output by the oscillator 54 may be determined in response to a control signal VGC provided from the controller 52. For example, the oscillator 54 may set the frequency and the swing range of the clock signal CLK differently according to the control signal VGC transmitted by the controller 52.

The charge pump circuit 56 may include a plurality of charge pumps, and each of the plurality of charge pumps may include a switch element and a pumping capacitor. The output voltage of the charge pump circuit 56 may be used for the operation of the semiconductor device 100. In some embodiments, the row decoder 32 may use the output voltage of the charge pump circuit 56 and input a bias voltage to the word lines WL to perform a program operation, an erase operation, and a read operation.

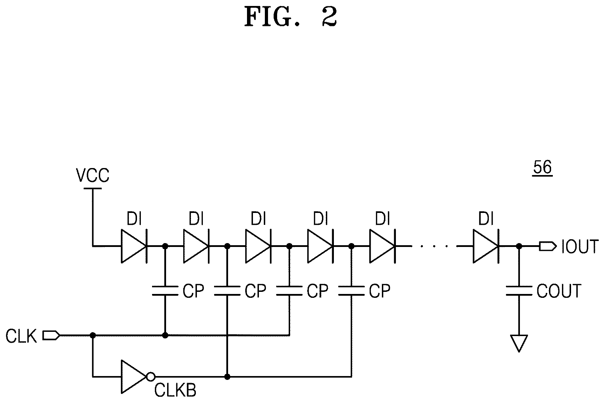

FIG. 2 is a circuit diagram showing the charge pump circuit 56 in the voltage generator 38 of the semiconductor device 100 of FIG. 1.

Referring to FIG. 2, the charge pump circuit 56 may include a plurality of diodes DI, a plurality of pumping capacitors CP, and an output capacitor COUT.

The plurality of diodes DI may be connected in series to each other, and the plurality of pumping capacitors CP may be respectively connected to nodes between the plurality of diodes DI. The first diode DI may receive a power supply voltage VCC having a preset level, and the last diode DI may output an output current IOUT to an output node.

Each of the plurality of pumping capacitors CP may be charged or discharged by the clock signal CLK or by a complementary clock signal CLKB that is phase-shifted by an inverter INV such that the complementary clock signal CLKB has an opposite phase to the clock signal CLK. For example, odd-numbered pumping capacitors CP may be charged or discharged by the clock signal CLK, and even-numbered pumping capacitors CP may be charged or discharged by the complementary clock signal CLKB.

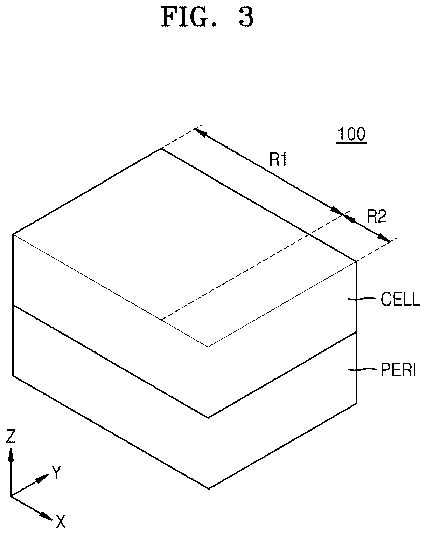

FIG. 3 is a perspective view schematically showing the semiconductor device 100 according to an embodiment.

Referring to FIG. 3, the semiconductor device 100 may include a peripheral circuit structure PERI and a memory cell structure CELL.

The memory cell array 20 (see FIG. 1) may be located in the memory cell structure CELL, and the peripheral circuit 30 (see FIG. 1) may be located in the peripheral circuit structure PERI. In some embodiments, the memory cell structure CELL may be disposed above the peripheral circuit structure PERI. In some embodiments, on the contrary, the memory cell structure CELL may be disposed below the peripheral circuit structure PERI. Regardless of whether the memory cell structure CELL is located above or below the peripheral circuit structure PERI, the memory cell structure CELL and the peripheral circuit structure PERI may be stacked upon one another in a first direction. The first direction may be referred to herein as a vertical direction Z. Horizontal directions may be defined perpendicular to the vertical direction Z. For instance, a first horizontal direction X and a second horizontal direction Y may be defined perpendicular to the vertical direction Z. The first horizontal direction X may cross (e.g., may be perpendicular to) the second horizontal direction Y. The vertical direction Z may define a height direction of the semiconductor device 100. Elements or features that are located further along the vertical direction Z may be considered "above" (or "higher than") other elements or features (which may be considered "below", or "lower than" the elements or features). That is, relative vertical levels may be defined based on relative positions along the vertical direction Z. It will be appreciated that the directions and positions defined herein are defined relative to the structure of the semiconductor device 100. Accordingly, the directions and positions need not imply any particular orientation of the semiconductor device 100 in use. In the embodiments described below, the vertical direction Z is defined such that the memory cell structure CELL is located "above" the peripheral circuit structure PERI in the vertical direction Z. Nevertheless, as noted above, this orientation may be changed.

In some embodiments, the memory cell structure CELL may include a first region R1 and a second region R2. The first region R1 may represent a cell region in which the memory cell array 20 (see FIG. 1) is arranged. The second region R2 may represent be a pad region for electrically connecting memory cells of the memory cell array 20 (see FIG. 1) to the peripheral circuit 30 (see FIG. 1). The second region R2 may be located at an end of the first region R1 in at least one direction, for example, in the first horizontal direction X.

The plurality of pumping capacitors CP constituting the charge pump circuit 56 (see FIG. 2) may be arranged in the peripheral circuit structure PERI. For example, the plurality of pumping capacitors CP may be arranged, in the peripheral circuit structure PERI, overlapping (e.g., below) the second region R2 of the memory cell structure CELL in the vertical direction Z.

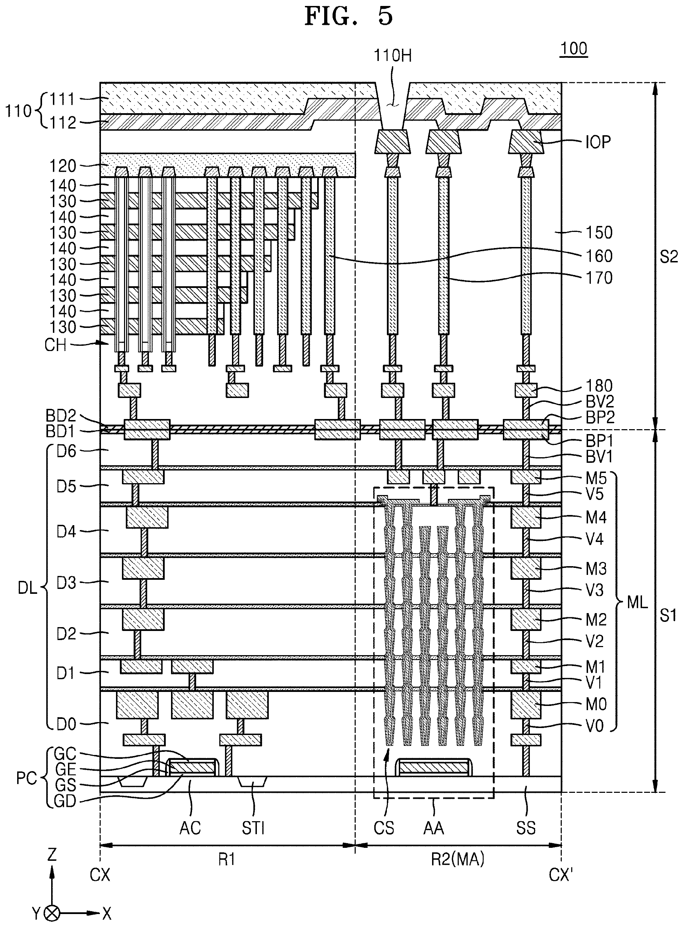

FIG. 4 is a plan view showing components of the semiconductor device 100 according to an embodiment. FIG. 5 is a cross-sectional view of the semiconductor device 100 taken along line CX-CX' of FIG. 4.

Referring to FIGS. 4 and 5, the semiconductor device 100 may include a first semiconductor structure S1 and a second semiconductor structure S2.

The first semiconductor structure S1 may correspond to the peripheral circuit structure PERI (see FIG. 3). The first semiconductor structure S1 may include a first substrate SS, which includes an active region AC defined by a device isolation region STI, peripheral circuit devices PC, which are disposed on the active region AC of the first substrate SS, a multi-layer wiring structure ML, which is connected to the peripheral circuit devices PC, a multi-layer insulating structure DL, which surrounds and insulates the multi-layer wiring structure ML, and a capacitor structure CS, which passes through the multi-layer insulating structure DL. In addition, the first semiconductor structure S1 may include first bonding vias BV1 and first bonding pads BP1, which are connected to the multi-layer wiring structure ML and the capacitor structure CS, and a first bonding insulating layer BD1, which surrounds the first bonding pads BP1. In the present context, an "active region" may be a region of a semiconductor structure (e.g., of a semiconductor layer or substrate) configured to form part of an active device (e.g., a transistor). For instance, a channel region of a transistor may be defined in at least a portion of an active region.

The first substrate SS may include a semiconductor material, for example, a group IV semiconductor, a group III-V compound semiconductor, or a group II-VI compound semiconductor. The first substrate SS may be provided as a bulk wafer or epitaxial layer. The first substrate SS may have a plane extending in the first horizontal direction X and a second horizontal direction Y. The active region AC may be defined, by device isolation regions STI, in the first substrate SS. An impurity region (not shown) containing impurities may be located in a part of the active region AC.

The peripheral circuit devices PC may include planar transistors. Each of the peripheral circuit devices PC may include a circuit gate dielectric layer GD, a circuit gate electrode layer GE, a circuit gate capping layer GC, and circuit gate spacers GS on both sidewalls thereof. On both sides of the circuit gate electrode layer GE, the impurity region may be arranged as a source/drain region inside the first substrate SS.

The multi-layer insulating structure DL may be disposed on the first substrate SS to cover the peripheral circuit devices PC. The multi-layer insulating structure DL may include a plurality of insulating layers D0 to D6 that are formed in different processes. Specifically, the plurality of insulating layers D0 to D6 may be referred to as a lowermost insulating layer D0, a first insulating layer D1, a second insulating layer D2, a third insulating layer D3, a fourth insulating layer D4, a fifth insulating layer D5, and a sixth insulating layer D6, which are arranged in this order in the vertical direction Z. In some embodiments, the number of layers of the plurality of insulating layers D0 to D6 may vary. The multi-layer insulating structure DL may include an insulating material, for example, silicon oxide or a low-k dielectric material. A low-k dielectric material may be a dielectric material having a dielectric constant that is lower than that of silicon oxide.

A plurality of wiring layers M0 to M5 and a plurality of via layers V0 to V5 may constitute the multi-layer wiring structure ML that is electrically connected to a peripheral circuit device PC. The multi-layer wiring structure ML may be referred to as a peripheral circuit wire (e.g., a peripheral circuit wiring structure). Each of the plurality of wiring layers M0 to M5 has a line shape, and each of the plurality of via layers V0 to V5 may have a pillar shape. Electrical signal(s) may be applied to the peripheral circuit devices PC by the plurality of wiring layers M0 to M5 and the plurality of via layers V0 to V5.

The plurality of via layers V0 to V5 may connect the plurality of wiring layers M0 to M5 to each other in the vertical direction Z. Specifically, the plurality of wiring layers M0 to M5 may be referred to as a lowermost wiring layer M0, a first wiring layer M1, a second wiring layer M2, a third wiring layer M3, a fourth wiring layer M4, and a fifth wiring layer M5. Also, the plurality of via layers V0 to V5 may be referred to as a lowermost via layer V0, a first via layer V1, a second via layer V2, a third via layer V3, a fourth via layer V4, and a fifth via layer V5. In some embodiments, the number of layers of the plurality of wiring layers M0 to M5 and the plurality of via layers V0 to V5 may vary. The multi-layer wiring structure ML may include a conductive material, for example, tungsten (W), copper (Cu), aluminum (Al), etc.

The number of wiring layers may be the same as the number of insulating layers. The number of via layers may be the same as the number of insulating layers and/or the number of wiring layers. In the plurality of insulating layers D0 to D6, the plurality of wiring layers M0 to M5, and the plurality of via layers V0 to V5, the same number may indicate that layers are located in the same layer. For example, the third insulating layer D3, the third wiring layer M3, and the third via layer V3 may all be located in a third layer.

Above the first substrate SS, the capacitor structure CS may be spaced apart from the multi-layer wiring structure ML in the horizontal direction (X or Y) and extend through the multi-layer insulating structure DL. The capacitor structure CS may at least partially overlap the multi-layer wiring structure ML in the horizontal direction (X or Y). In some embodiments, the capacitor structure CS may correspond to the plurality of pumping capacitors CP (see FIG. 2) and/or the output capacitor COUT (see FIG. 2) and may be located in a wiring region MA. The capacitor structure CS is described in detail below.

The second semiconductor structure S2 may correspond to the memory cell structure CELL (see FIG. 3). The second semiconductor structure S2 may include a passivation layer 110, which has the first region R1 and the second region R2, a stack structure, which includes gate electrodes 130 and interlayer insulating layers 140 alternately stacked in the first region R1, channel structures CH, which extend through the stack structure, input/output pads IOP, which are open to the outside via an opening 110H in the second region R2, and a cover insulating layer 150, which covers the first region R1 and the second region R2. Also, the second semiconductor structure S2 may include contact plugs 160, which extend through the cover insulating layer 150 in the first region R1 and are connected to ends of the gate electrodes 130, and through-plugs 170, which extend through the cover insulating layer 150 in the second region R2 and are connected to the input/output pads IOP. In addition, the second semiconductor structure S2 may include a cell wiring structure 180 that is electrically connected to the channel structures CH, the contact plugs 160, and/or the through-plugs 170. Also, the second semiconductor structure S2 may include second bonding vias BV2 and second bonding pads BP2, which are connected to the cell wiring structure 180, and a second bonding insulating layer BD2, which surrounds the second bonding pads BP2.

In the second semiconductor structure S2, the first region R1 may represent a region in which the gate electrodes 130 are vertically stacked on each other to form memory cells or are connected to the contact plugs 160, and the second region R2 may represent an outer region of the memory cells in which the input/output pads IOP are arranged.

The passivation layer 110 may include first and second passivation layers 111 and 112 stacked on one another. The first passivation layer 111 may include a different insulating material than the second passivation layer 112. For example, the first passivation layer 111 may include photosensitive polyimide (PSPI), and the second passivation layer 112 may include silicon oxide, silicon nitride, or silicon carbide. The passivation layer 110 may have the opening 110H, and the input/output pads IOP may be exposed to the outside via the opening 110H.

The gate electrodes 130 may be stacked on a conductive plate 120, spaced apart from each other in the vertical direction Z, and form the stack structure together with the interlayer insulating layers 140. The gate electrodes 130 may include lower gate electrodes, which form string selection transistors, memory gate electrodes, which form a plurality of memory cells, and upper gate electrodes, which form ground selection transistors. The number of gate electrodes 130 may be determined according to the storage capacity of the semiconductor device 100.

The gate electrodes 130 may extend in the horizontal direction (e.g., X or Y) by different lengths, thereby forming a stepped structure. Due to the stepped structure, contact regions at the ends of the gate electrodes 130 may be respectively connected to the contact plugs 160. The gate electrodes 130 may include a metal material, such as tungsten (W). The gate electrodes 130 may include the same material.

The interlayer insulating layers 140 may be arranged between the gate electrodes 130. The interlayer insulating layers 140 may be stacked on the upper surface of the conductive plate 120 and spaced apart from each other in the vertical direction Z. The interlayer insulating layers 140 may include an insulating material, such as silicon oxide and silicon nitride.

The channel structures CH may extend through the stack structure in the vertical direction Z and may be connected to the conductive plate 120. The channel structures CH each may form a single memory cell string and may be arranged in rows and columns on the conductive plate 120 while being spaced apart from each other. The channel structures CH each may have a pillar shape having a large aspect ratio and may have inclined sidewalls such that the channel structure CH becomes narrower toward the conductive plate 120. The channel structures CH each may include a channel layer, a gate dielectric layer, a channel buried insulating layer, and a channel pad, which are arranged in a channel hole.

The cover insulating layer 150 may cover the stack structure, the contact plugs 160, the through-plugs 170, and the cell wiring structure 180, etc. The cover insulating layer 150 may include an insulating material and may be provided as a plurality of insulating layers.

The contact plugs 160 may be arranged in the first region R1 and connected to the contact regions at the ends of the gate electrodes 130. The contact plugs 160 may at least partially extend through the cover insulating layer 150 in the first region R1 and may be respectively connected to the contact regions of the gate electrodes 130. The contact plugs 160 may include a conductive material, for example, at least one of tungsten (W), copper (Cu), aluminum (Al), or an alloy thereof.

The through-plugs 170 may be arranged in the second region R2 and may be connected to the input/output pads IOP through the cover insulating layer 150. The through-plugs 170 may include a conductive material, for example, at least one of tungsten (W), copper (Cu), aluminum (Al), or an alloy thereof. The through-plugs 170 and the contact plugs 160 may be formed in the same process, and may thus include the same material and have the same inner structure.

The cell wiring structure 180 may include a wiring line that is electrically connected to the memory cells. The cell wiring structure 180 may be electrically connected to the channel structures CH, the contact plugs 160, and/or the through-plugs 170. The cell wiring structure 180 may include a conductive material, for example, at least one of tungsten (W), copper (Cu), aluminum (Al), or an alloy thereof.

The first semiconductor structure S1 and the second semiconductor structure S2 may be brought into contact with and directly bonded to each other by hybrid bonding, and thus, an electrical connection therebetween may be formed. For example, a first bonding pad BP1 and a second bonding pad BP2 may be brought into contact with and coupled to each other by metal-to-metal bonding, and the first bonding insulating layer BD1 and the second bonding insulating layer BD2 may be brought into contact with and coupled to each other by dielectric-to-dielectric bonding. The first bonding pad BP1 and the second bonding pad BP2 may provide an electrical connection path according to the bonding between the first semiconductor structure S1 and the second semiconductor structure S2.

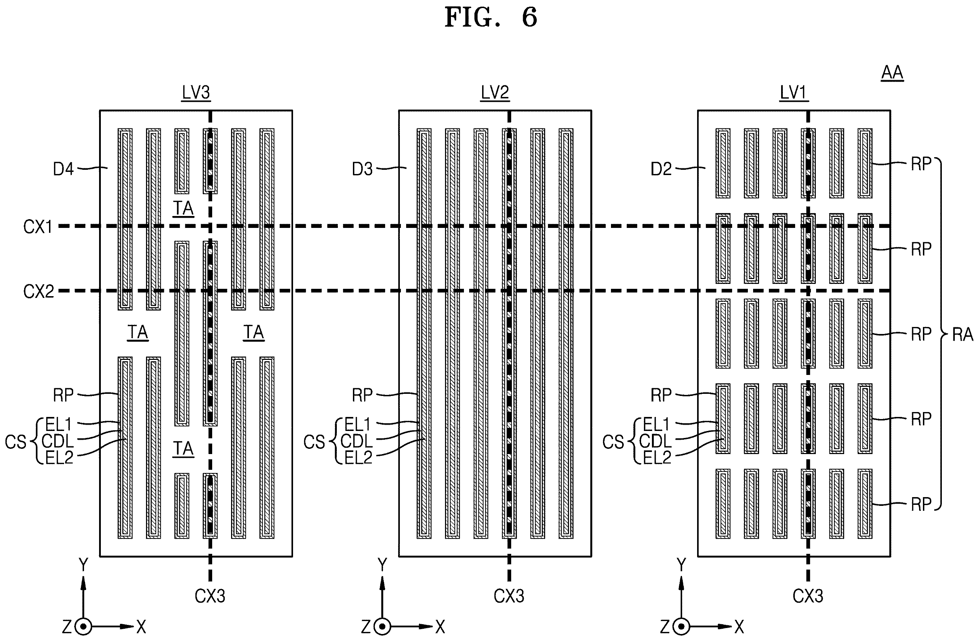

The capacitor structure CS in the semiconductor device 100 according to the inventive concept may correspond to the plurality of pumping capacitors CP (see FIG. 2) and/or the output capacitor COUT (see FIG. 2). In addition, a part of the multi-layer wiring structure ML may be replaced by a replacement process, and thus, the area of the capacitor structure CS may increase, thereby improving the electrical characteristics and reliability. The technical features of the capacitor structure CS are described in detail below with reference to FIGS. 6 through 12.

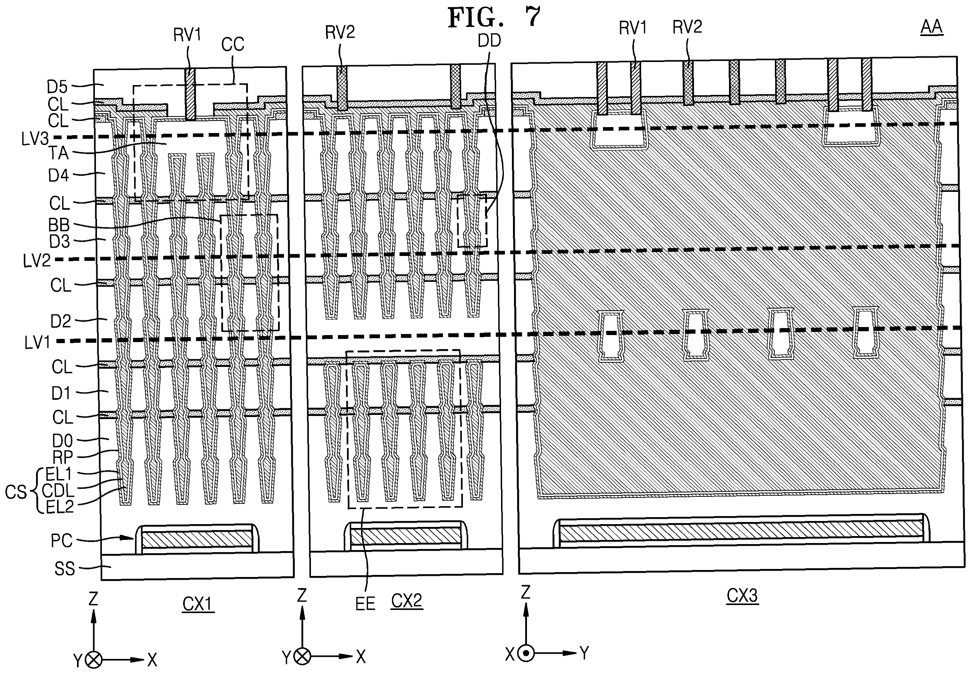

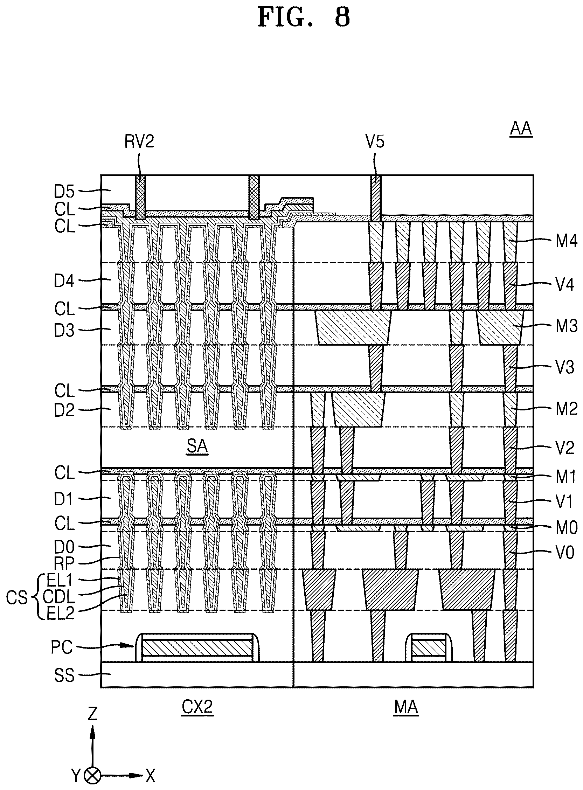

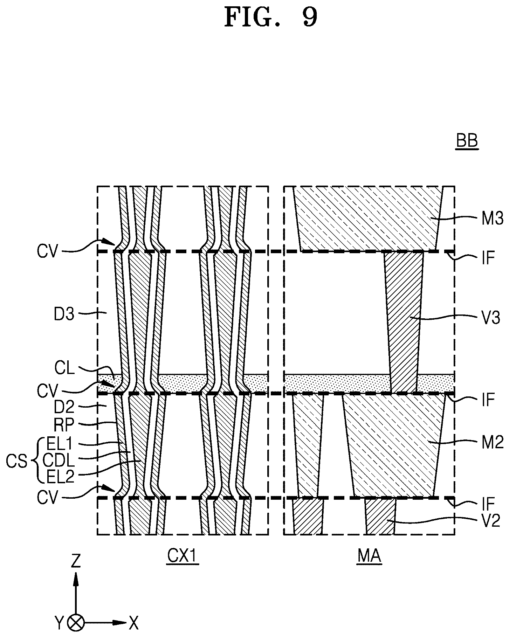

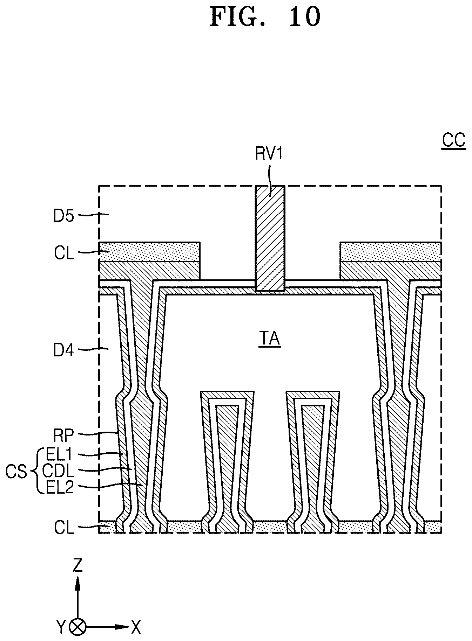

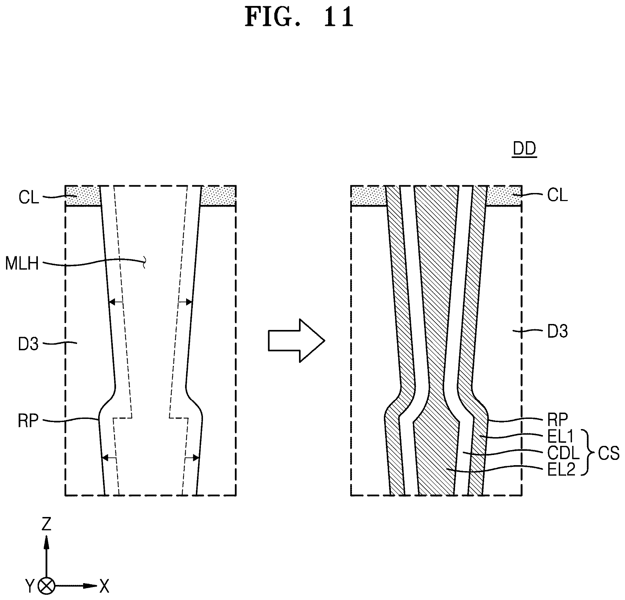

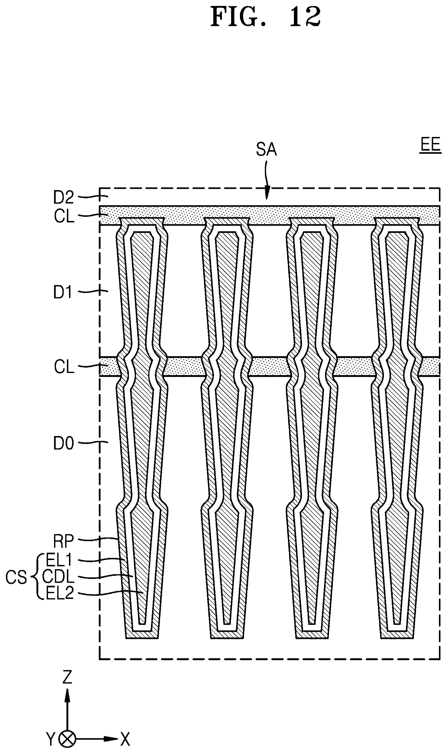

FIG. 6 is a plan view showing a capacitor structure of a semiconductor device, according to an embodiment, with respect to a first level LV1, a second LV2, and a third level LV3. FIG. 7 is a cross-sectional view of the capacitor structure taken along lines CX1, CX2, and CX3 of FIG. 6. FIG. 8 is a cross-sectional view showing a comparison between a wiring region and a partial region of FIG. 7. FIG. 9 is an enlarged view of region BB of FIG. 7. FIG. 10 is an enlarged view of region CC of FIG. 7. FIG. 11 is an enlarged view of region DD of FIG. 7. FIG. 12 is an enlarged view of region EE of FIG. 7. In the resent context, a level (e.g., vertical level) may refer to a relative position along the vertical direction Z.

Referring to FIGS. 6 through 12, in the semiconductor device 100, the first semiconductor structure S1 may include the capacitor structure CS.

The capacitor structure CS according to the inventive concept may include a metal-insulator-metal (MIM) capacitor. The capacitor structure CS may include a first electrode layer EL1, which is conformally formed along the inner wall of a recess region RA that at least partially passes through the multi-layer insulating structure DL, a capacitor dielectric layer CDL, which is conformally formed along the inner wall of the first electrode layer EL1, and a second electrode layer EL2, which is in contact with the inner wall of the capacitor dielectric layer CDL and fills the recess region RA. In this case, the first electrode layer EL1 may be referred to as a lower electrode, and the second electrode layer EL2 may be referred to as an upper electrode.

In the capacitor structure CS according to the inventive concept, a first routing via RV1 may be in contact with and electrically connected to the first electrode layer EL1, and a second routing via RV2 may be in contact with and electrically connected to the second electrode layer EL2. In this case, at least a part of the first routing via RV1 in contact with the upper surface of the first electrode layer EL1 may be at the same vertical level as at least a part of the second routing via RV2 in contact with the upper surface of the second electrode layer EL2. For instance, the first routing via RV1 may be in contact with an upper surface of the first electrode layer EL1, the second routing via RV2 may be in contact with an upper surface of the second electrode layer EL2, and at least a part of the first routing via RV1 may be positioned at the same vertical level (e.g., substantially the same vertical level) as at least a part of the second routing via RV2.

Specifically, both the first routing via RV1 and the second routing via RV2 may be disposed above the capacitor structure CS. In addition, the uppermost end of the first routing via RV1 may be at substantially the same vertical level as the uppermost end of the second routing via RV2, and the lowermost end of the first routing via RV1 may be at a lower vertical level than the lowermost end of the second routing via RV2. The uppermost ends of the first and second routing vias RV1 and RV2 may be ends opposite (in the vertical direction Z) to the ends that contact the capacitor structure CS. The lowermost ends of the first and second routing vias RV1 and RV2 may be the ends that contact the capacitor structure CS. As used herein, the expression "substantially the same" may refer to having the same value relative to other value(s) compared therewith, as will be appreciated by those of skill in the art, and allows for approximations, inaccuracies and limits of measurement under the relevant circumstances. In one or more aspects, the terms "substantially," "about," and "approximately" may provide an industry-accepted tolerance for their corresponding terms and/or relativity between items, such as a tolerance of ± 1%, ± 5% , or ± 10% of the actual value stated, and other suitable tolerances.

In the capacitor structure CS according to the inventive concept, the first routing via RV1 and the second routing via RV2 each may extend through the fifth insulating layer D5 of the multi-layer insulating structure DL. The first routing via RV1 and the second routing via RV2 may be electrically connected to a first bonding via BV1 via the fifth wiring layer M5. The first routing via RV1 and the second routing via RV2 may be electrically connected to the cell wiring structure 180 via the first bonding via BV1, the first bonding pad BP1, the second bonding pad BP2, and a second bonding via BV2. Next, the first routing via RV1 and the second routing via RV2 may be electrically connected to the input/output pads IOP via the cell wiring structure 180 and the through-plugs 170.

That is, in the semiconductor device 100 according to the inventive concept, the capacitor structure CS of the first semiconductor structure S1 may operate as a component of the charge pump circuit 56 (see FIG. 2) via the input/output pads IOP of the second semiconductor structure S2.

In the semiconductor device 100 according to the inventive concept, the recess region RA may include a plurality of recess patterns RP that extend in the vertical direction Z and are spaced apart from each other in the horizontal direction (X or Y). Here, there may be a tab region TA in which the uppermost ends of some of the plurality of recess patterns RP located below the first routing via RV1 are at lower vertical levels than the uppermost ends of the other recess patterns RP. That is, uppermost ends of portions of the second electrode layer EL2 located beneath the first routing via RV1 may be positioned at lower vertical levels than uppermost ends of other parts of the second electrode layer EL2. The tab region TA may represent an insulating region for preventing the first routing via RV1 from coming into contact with the second electrode layer EL2. The tab region TA may be a region located underneath (e.g., overlapping in the vertical direction Z) the first routing via RV1.

In the capacitor structure CS according to the inventive concept, the first electrode layer EL1, the capacitor dielectric layer CDL, and the second electrode layer EL2 may completely fill the plurality of recess patterns RP and continuously extend in the horizontal direction (X or Y) while being connected to each other. Also, the first electrode layer EL1, the capacitor dielectric layer CDL, and the second electrode layer EL2 may extend through capping insulating layers CL of the multi-layer insulating structure DL and extend lengthwise in the vertical direction Z.

The first electrode layer EL1 located on the sidewall of each of the plurality of recess patterns RP may have a plurality of curved sections CV spaced apart from each other in the vertical direction Z, and the vertical levels of the plurality of curved sections CV may be substantially the same as the vertical levels of bonding interfaces IF of the multi-layer wiring structure ML. In some embodiments, at least some of the plurality of curved sections CV may have a rounded shape. Each curved section CV may be a section of a sidewall of the first electrode layer EL1 (e.g., within one recess pattern RP) that is curved along a plane running in the vertical direction Z. For instance, at each curved section CV the width of the of the first electrode layer EL1 (e.g., within one recess pattern RP) may increase when moving downwards (e.g., towards the first substrate SS). The capacitor dielectric layer CDL may have a concave-convex shape corresponding to the plurality of curved sections CV. The concave-convex shape may refer to the outer sidewall of the capacitor dielectric layer CDL (e.g., within one recess pattern RP) having alternating concave and convex sections along the length of the capacitor dielectric layer CDL (e.g., in the vertical direction Z).

Based on these features, in the manufacturing process described below, the interior of the plurality of wiring openings MLH may be cleaned and, if necessary, a wet etching process may be performed thereon. Accordingly, the plurality of recess patterns RP may have a relatively wider interior than the plurality of wiring openings MLH. Also, the inner walls of the plurality of recess patterns RP may have a relatively smooth (or rounded) shape compared to the inner walls of the plurality of wiring openings MLH. Given this, each portion of the capacitor structure CS within a corresponding recess pattern RP may have a width (e.g., in the first horizontal direction X and/or in the second horizontal direction Y) that is larger than the width (e.g., in the first horizontal direction X and/or in the second horizontal direction Y) of corresponding vias in the via layers V1-V5. For instance, within a given one of the insulating layers D1-D0, each vertically extending portions of the capacitor structure CS may be wider (e.g., have a wider width and/or a larger cross-section) than each vertically extending via. The width may refer to a maximum width.

In some cross-sections of the capacitor structure CS according to the inventive concept, the first electrode layer EL1, the capacitor dielectric layer CDL, and the second electrode layer EL2 may be separated from each other in the vertical direction Z to form a complete closed curved surface. That is, since the capacitor structure CS is formed long in the vertical direction Z, it is necessary to prevent the capacitor structure CS from deflecting. Therefore, a support region SA, in which an insulating layer (e.g., the second insulating layer D2) is formed continuously and lengthwise in the first horizontal direction X, may be provided in a middle region of the capacitor structure CS so as to serve as a support. The capacitor structure CS may extend around (e.g., on either side in the second horizontal direction Y) the support region SA.

Ultimately, the capacitor structure CS in the semiconductor device 100 according to the inventive concept may be formed by partially replacing the multi-layer wiring structure ML in the wiring region MA via a replacement process. Accordingly, the capacitor structure CS may increase in area and may be used in various voltage bands according to adjustments in the thickness of the capacitor dielectric layer CDL, thereby improving the electrical characteristics and reliability of the semiconductor device 100 that includes the capacitor structure CS.

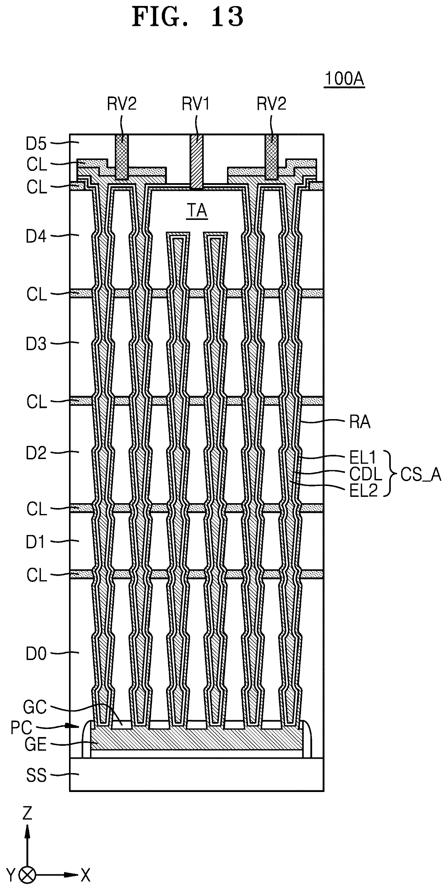

FIGS. 13 through 15 are cross-sectional views showing semiconductor devices 100A, 100B, and 100C according to some embodiments.

Most of components constituting the semiconductor devices 100A, 100B, and 100C described below and materials constituting these components are substantially the same as or similar to those described above in FIGS. 4 through 12. Therefore, for convenience of description, the description focuses on differences from the semiconductor device 100 described above.

Referring to FIG. 13, in the semiconductor device 100A, the first semiconductor structure S1 may include a capacitor structure CS_A.

In the semiconductor device 100A according to the embodiment, the capacitor structure CS_A may include a first electrode layer EL1, which is conformally formed along an inner wall of a recess region RA that at least partially passes through the multi-layer insulating structure DL, a capacitor dielectric layer CDL, which is conformally formed along the inner wall of the first electrode layer EL1, and a second electrode layer EL2, which is in contact with the inner wall of the capacitor dielectric layer CDL and fills the recess region RA.

In the semiconductor device 100A according to the embodiment, the recess region RA may overlap the peripheral circuit device PC in the vertical direction Z, and the lowermost surface of the recess region RA may be at a lower vertical level than the uppermost surface of the peripheral circuit device PC. That is, the first electrode layer EL1 of the capacitor structure CS_A may extend through the circuit gate capping layer GC and may be formed integrally with the circuit gate electrode layer GE. In this case, the peripheral circuit device PC may not operate as a transistor and may constitute a part of the capacitor structure CS_A.

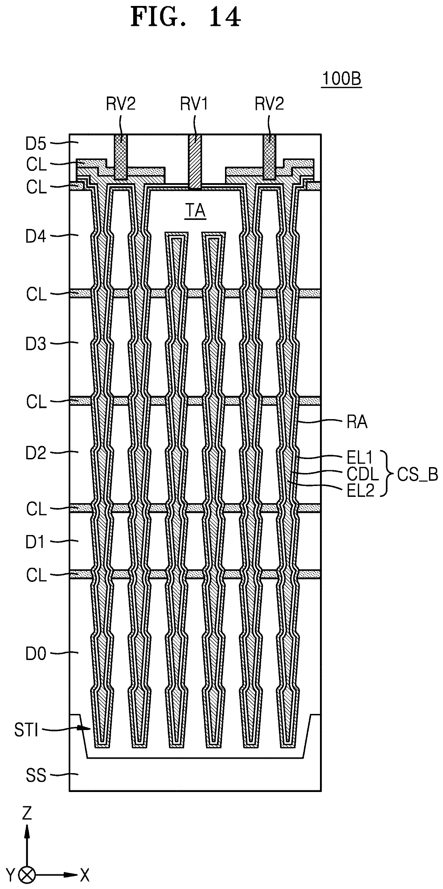

Referring to FIG. 14, in the semiconductor device 100B, the first semiconductor structure S1 may include a capacitor structure CS_B.

In the semiconductor device 100B according to the embodiment, the capacitor structure CS_B may include a first electrode layer EL1, which is conformally formed along an inner wall of a recess region RA that at least partially passes through the multi-layer insulating structure DL, a capacitor dielectric layer CDL, which is conformally formed along the inner wall of the first electrode layer EL1, and a second electrode layer EL2, which is in contact with the inner wall of the capacitor dielectric layer CDL and fills the recess region RA.

In the semiconductor device 100B according to the embodiment, the recess region RA may overlap the device isolation region STI in the vertical direction Z, and the lowermost surface of the recess region RA may be at a lower vertical level than the uppermost surface of the device isolation region STI. That is, the capacitor structure CS_B may extend through at least a portion (or an upper portion) of the device isolation region STI.

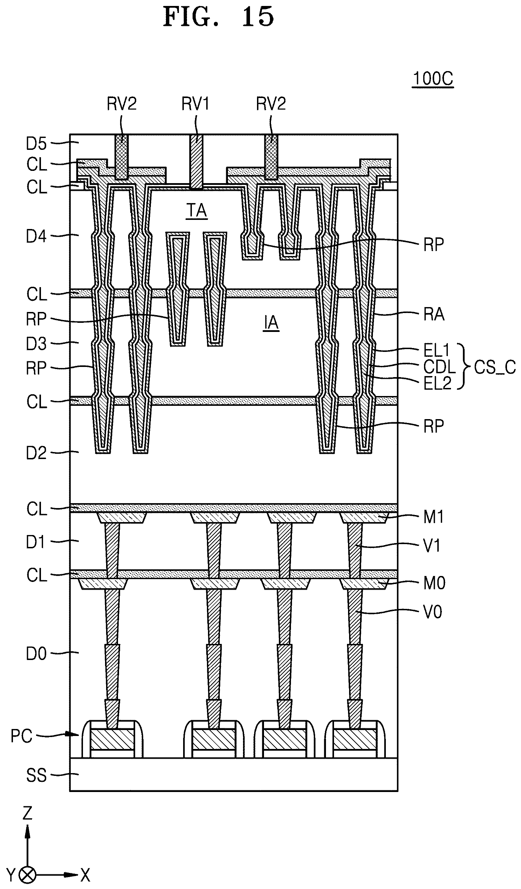

Referring to FIG. 15, in the semiconductor device 100C, the first semiconductor structure S1 may include a capacitor structure CS_C.

In the semiconductor device 100C according to the embodiment, the capacitor structure CS_C may include a first electrode layer EL1, which is conformally formed along an inner wall of a recess region RA that at least partially passes through the multi-layer insulating structure DL, a capacitor dielectric layer CDL, which is conformally formed along the inner wall of the first electrode layer EL1, and a second electrode layer EL2, which is in contact with the inner wall of the capacitor dielectric layer CDL and fills the recess region RA.

In the semiconductor device 100C according to the embodiment, the capacitor structure CS_C may overlap, in the vertical direction Z, the lowermost wiring layer M0 and the first wiring layer M1 among the plurality of wiring layers M0 to M5 and the lowermost via layer V0 and the first via layer V_1 among the plurality of via layers V0 to V5. In this case, the lowermost end of the capacitor structure CS_C may be at various vertical levels. That is, the lowermost surface of at least one of the plurality of recess patterns RP may be at a different vertical level than the lowermost surfaces of the other recess patterns RP. Accordingly, the multi-layer wiring structure ML may be partially located in an inner space IA between capacitor structures CS_C, thereby increasing the degree of freedom of wiring.

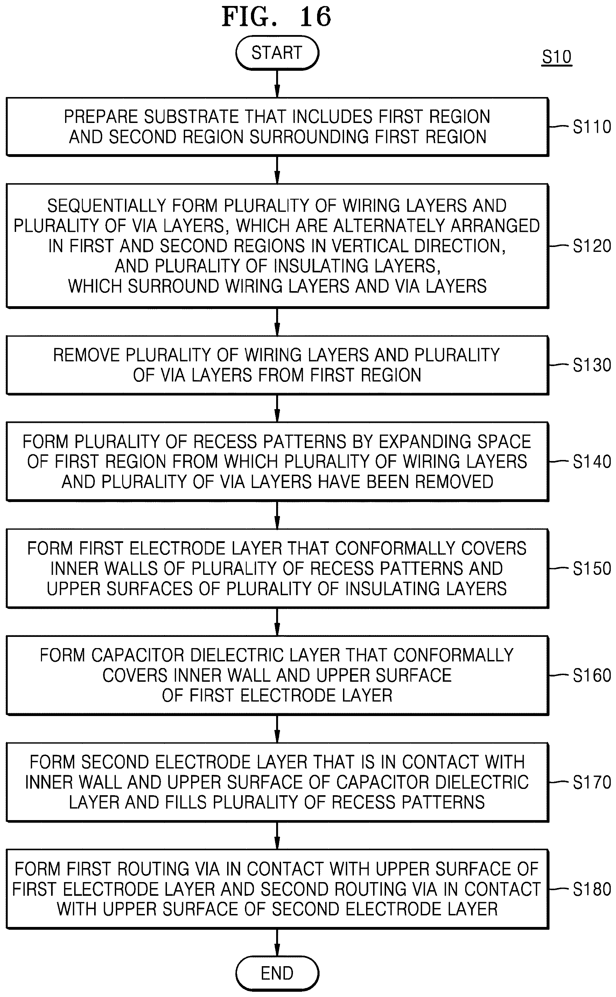

FIG. 16 is a flowchart showing a semiconductor device manufacturing method according to an embodiment.

Referring to FIG. 16, a semiconductor device manufacturing method S10 may include first through eighth operations S110-S180.

When an embodiment may be implemented in a different manner, a specific process order may be different from that described below. For example, two processes described in succession may be performed substantially simultaneously or performed in the reverse order to that described.

The semiconductor device manufacturing method S10 according to the inventive concept may include first operation S110 of preparing a substrate that includes a first region and a second region surrounding the first region, second operation S120 of sequentially forming a plurality of wiring layers and a plurality of via layers, which are alternately arranged in the first and second regions in a vertical direction, and a plurality of insulating layers, which surround the wiring layers and the via layers, third operation S130 of removing the plurality of wiring layers and the plurality of via layers from the first region, fourth operation S140 of forming a plurality of recess patterns by expanding a space of the first region from which the plurality of wiring layers and the plurality of via layers have been removed, fifth operation S150 of forming a first electrode layer that conformally covers the inner walls of the plurality of recess patterns and the upper surfaces of the plurality of insulating layers, sixth operation S160 of forming a capacitor dielectric layer that conformally covers the inner wall and upper surface of the first electrode layer, seventh operation S170 of forming a second electrode layer that is in contact with the inner wall and upper surface of the capacitor dielectric layer and fills the plurality of recess patterns, and eighth operation S180 of forming a first routing via in contact with the upper surface of the first electrode layer and a second routing via in contact with the upper surface of the second electrode layer.

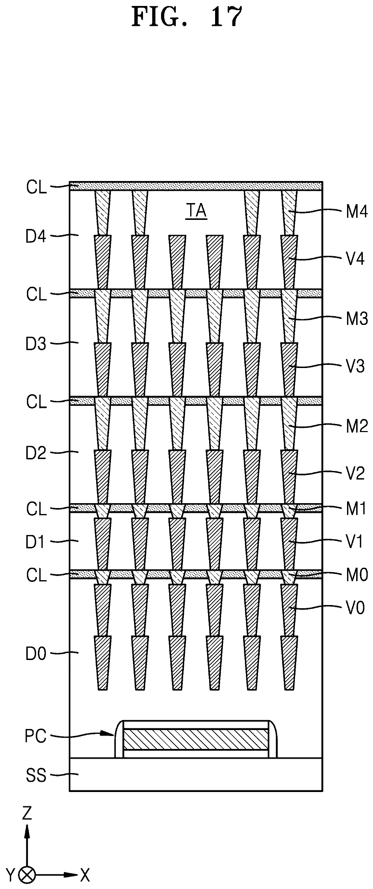

The technical features of each of first through eighth operations S110-S180 are described below in detail with reference to FIGS. 17 through 27.

FIGS. 17 through 27 are cross-sectional views showing, in a process sequence, a semiconductor device manufacturing method according to an embodiment.

Referring to FIG. 17, the first substrate SS, on which the peripheral circuit devices PC are formed, may be prepared.

The first substrate SS may include a semiconductor material, for example, a group IV semiconductor, a group III-V compound semiconductor, or a group II-VI compound semiconductor.

Next, the plurality of wiring layers M0 to M4, the plurality of via layers V0 to V4, and the plurality of insulating layers D0 to D4 surrounding the wiring layers M0 to M4 and the via layers V0 to V4 may be sequentially formed on the first substrate SS in the vertical direction Z. A capping insulating layer CL may be formed at each of the interlayer interfaces between the plurality of insulating layers D0 to D4.

Specifically, the lowermost insulating layer D0 and the capping insulating layer CL may be formed on the first substrate SS and then patterned (e.g., by a dry etching process) to form recesses. Next, the lowermost via layer V0 and the lowermost wiring layer M0 may fill the recesses. By repeating processes similar to those described above, the multi-layer wiring structure ML and the multi-layer insulating structure DL may be formed on the first substrate SS. Accordingly, each of the plurality of wiring layers M0 to M4 and the plurality of via layers V0 to V4 may have a tapered shape that decreases in width toward the first substrate SS.

One or more sections of the fourth via layer V4 may be covered by a corresponding tab region TA of the fourth insulating layer D4. For instance, the fourth insulating layer D4 may not be etched above these sections of the fourth via layer V4, and so the fourth metal layer M4 may not be formed in the tab region TA. In a similar manner, one or more support regions SA may be formed in one or more of the plurality of insulating layers D0 to D4.

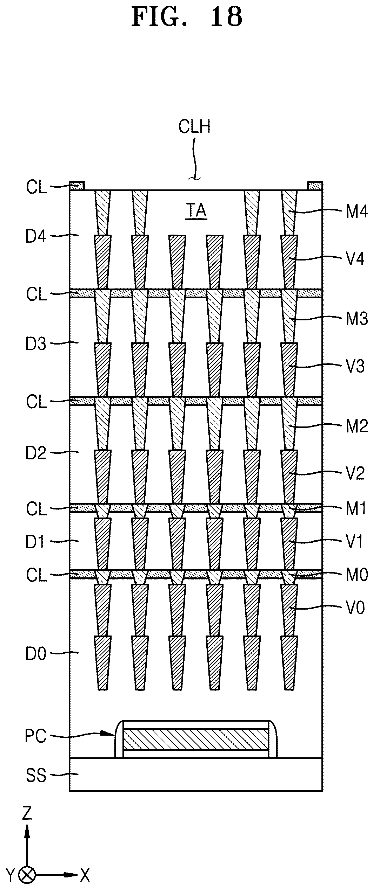

Referring to FIG. 18, the capping insulating layer CL located uppermost in the resulting structure of FIG. 17 may be partially removed to form a capping opening CLH that exposes the fourth wiring layer M4. The capping opening CLH may overlap a region in which the capacitor structure CS is to be formed. The capping insulating layer CL may remain covering one or more regions where the multi-layer wiring structure ML is to remain.

A photomask (not shown) may be formed, by an exposure process and a development process, on the capping insulating layer CL located uppermost, and then, an etching process may be performed thereon by using the photomask as an etching mask, thereby forming the capping opening CLH.

The exposure process, the development process, and the etching process described above are well known to those skilled in the art, and thus, detailed descriptions thereof are omitted herein.

After the capping opening CLH is formed, the photomask may be removed by ashing and stripping processes.

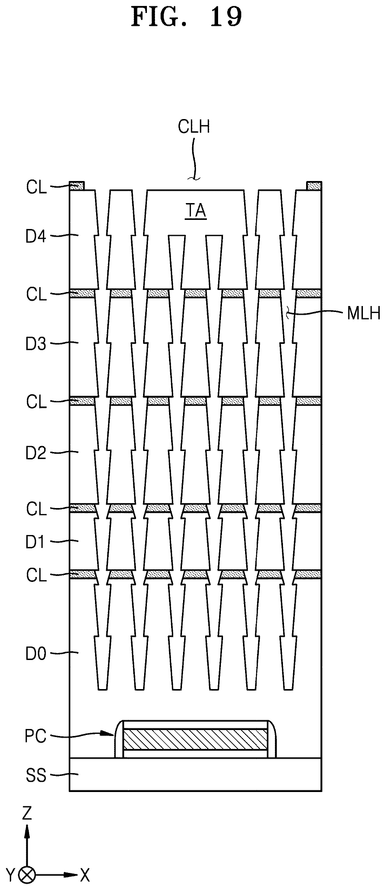

Referring to FIG. 19, the multi-layer wiring structure ML exposed in the resulting structure of FIG. 18 may be sequentially and completely removed.

Specifically, the fourth wiring layer M4 and the fourth via layer V4 may be removed, the third wiring layer M3 and the third via layer V3 exposed by the removal of the fourth wiring layer M4 and the fourth via layer V4 may be removed, the second wiring layer M2 and the second via layer V2 exposed by the removal of the third wiring layer M3 and the third via layer V3 may be removed, the first wiring layer M1 and the first via layer V1 exposed by the removal of the second wiring layer M2 and the second via layer V2 may be removed, and the lowermost wiring layer M0 and the lowermost via layer V0 exposed by the removal of the first wiring layer M1 and the first via layer V1 may be removed.

As a result, the plurality of wiring openings MLH may extend lengthwise in the vertical direction Z inside the multi-layer insulating structure DL.

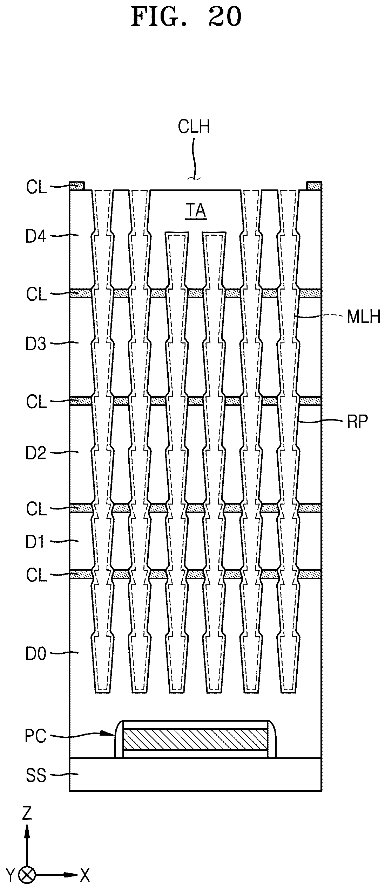

Referring to FIG. 20, the interior of the plurality of wiring openings MLH in the resulting structure of FIG. 19 may be cleaned and, if necessary, a wet etching process may be performed thereon. Accordingly, the plurality of recess patterns RP may be formed.

According to the cleaning and wet etching processes, the plurality of recess patterns RP may have a relatively wider interior than the plurality of wiring openings MLH. Also, the inner walls of the plurality of recess patterns RP may have a relatively smooth (or rounded) shape compared to the inner walls of the plurality of wiring openings MLH.

The sidewall of each of the plurality of recess patterns RP may have a plurality of curved sections spaced apart from each other in the vertical direction Z, and the formation of the plurality of curved sections may be a feature caused by the tapered shapes of the plurality of wiring layers M0 to M4 (see FIG. 18) and the plurality of via layers V0 to V4 (see FIG. 18) and the bonding interfaces therebetween.

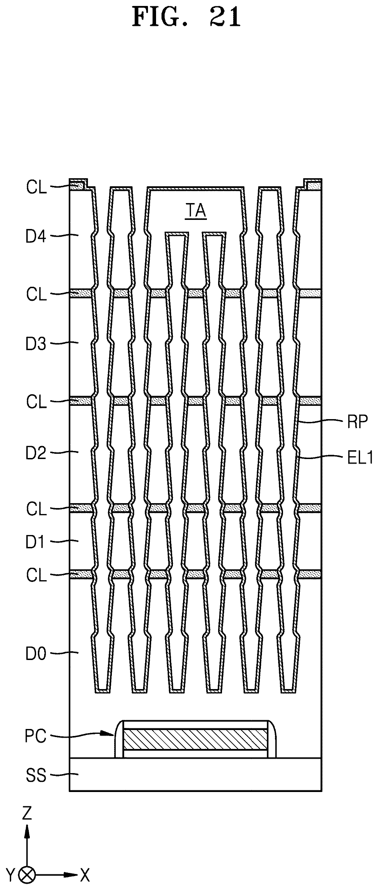

Referring to FIG. 21, the first electrode layer EL1 may be formed in the resulting structure of FIG. 20 to conformally cover the inner walls of the plurality of recess patterns RP, the upper surface of the fourth insulating layer D4, and the upper surface of the uppermost capping insulating layer CL.

The first electrode layer EL1 may be formed by a chemical vapor deposition (CVD) process or an atomic layer deposition (ALD) process.

The first electrode layer EL1 may include any one of metal nitride, metal, and a combination thereof. For example, the first electrode layer EL1 may include at least one selected from a group consisting of TiN, TaN, WN, Ru, Pt, and Ir.

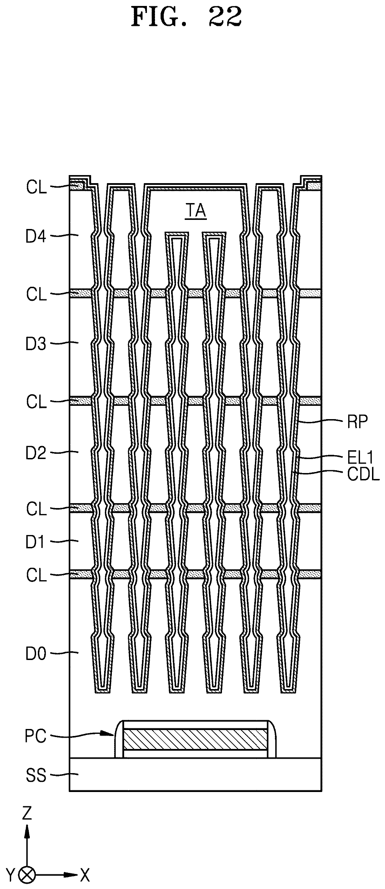

Referring to FIG. 22, the capacitor dielectric layer CDL may be formed in the resulting structure of FIG. 21 to conformally cover the inner wall and upper surface of the first electrode layer EL1.

The capacitor dielectric layer CDL may include at least one selected from a group consisting of silicon oxide, silicon nitride, silicon oxynitride, and a high-k dielectric material. A high-k dielectric material may be a dielectric material having a dielectric constant that is higher than that of silicon oxide.

The capacitor dielectric layer CDL may electrically separate the first electrode layer EL1 from the second electrode layer EL2 formed in the subsequent process, thereby functioning as a capacitor.

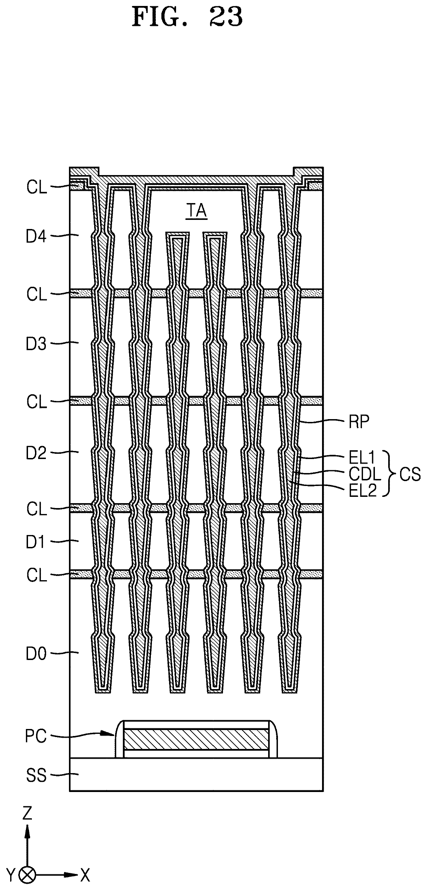

Referring to FIG. 23, the second electrode layer EL2 may be formed in the resulting structure of FIG. 22 such that the second electrode layer EL2 is in contact with the inner wall and upper surface of the capacitor dielectric layer CDL and completely fill the plurality of recess patterns RP.

The second electrode layer EL2 may be formed by a CVD process or an ALD process.

The second electrode layer EL2 may include any one of metal nitride, metal, and a combination thereof. For example, the second electrode layer EL2 may include at least one selected from a group consisting of TiN, TaN, WN, Ru, Pt, and Ir.

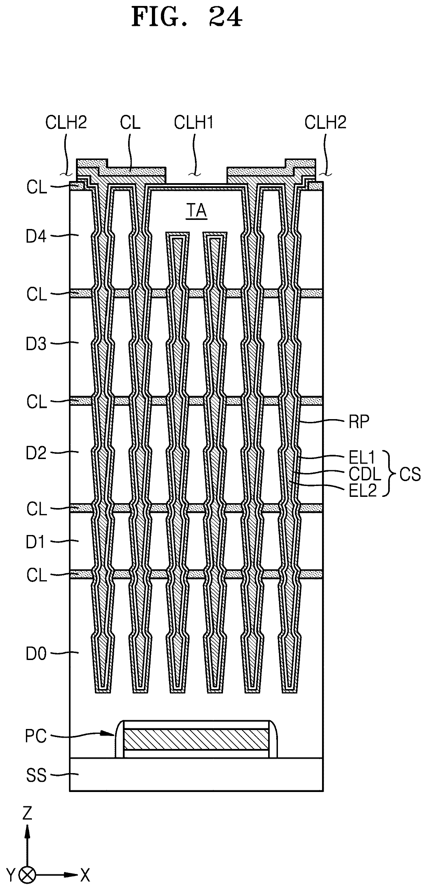

Referring to FIG. 24, the capping insulating layer CL may be formed on the second electrode layer EL2 in the resulting structure of FIG. 23.

Next, a photomask (not shown) may be formed, by an exposure process and a development process, on the capping insulating layer CL, and then, an etching process may be performed thereon by using the photomask as an etching mask, thereby forming a first opening CLH1 and a second opening CLH2.

The first opening CLH1 may be formed by removing the capping insulating layer CL and the second electrode layer EL2 above the tab region TA. On the other hand, the second opening CLH2 may be formed by removing the capping insulating layer CL, the second electrode layer EL2, the capacitor dielectric layer CDL, and the first electrode layer EL1 on an edge region.

The exposure process, the development process, and the etching process described above are well known to those skilled in the art, and thus, detailed descriptions thereof are omitted herein.

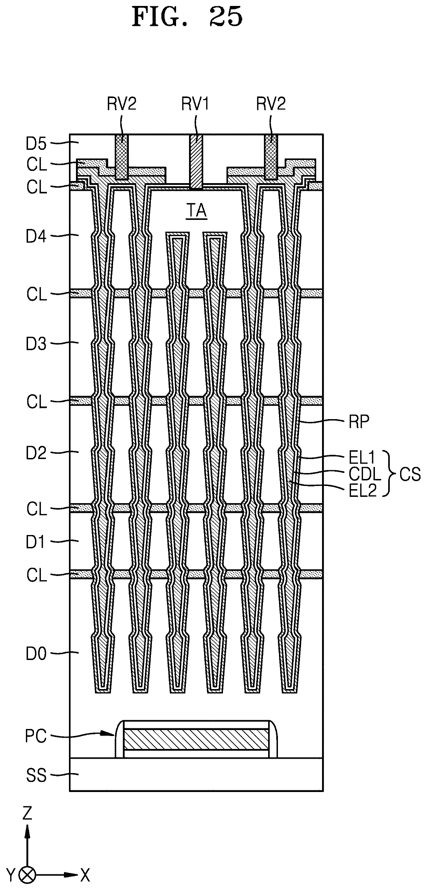

Referring to FIG. 25, the fifth insulating layer D5 may be formed in the resulting structure of FIG. 24 to cover the first opening CLH1 and the second opening CLH2. The fifth insulating layer D5 may fill the first opening CLH1 and the second opening CLH2.

Next, the first routing via RV1 and the second routing via RV2 may be formed to extend through the fifth insulating layer D5. The first routing via RV1 may be formed on the tab region TA such that the first routing via RV1 is in contact with the upper surface of the first electrode layer EL1, and the second routing via RV2 may be formed adjacent to (e.g., around) the tab region TA such that the second routing via RV2 is in contact with the upper surface of the second electrode layer EL2.

That is, at least a part of the first routing via RV1 may be formed at the same vertical level as at least a part of the second routing via RV2.

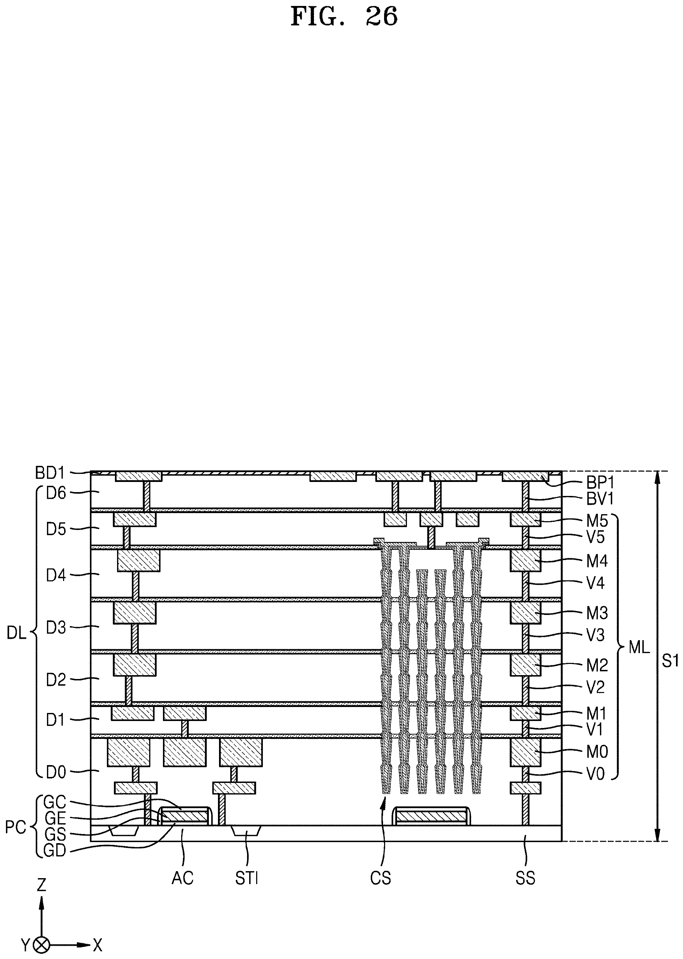

Referring to FIG. 26, the first semiconductor structure S1 may be formed, including the resulting structure of FIG. 25.

Particularly, the first bonding vias BV1 and the first bonding pads BP1 may be connected to the multi-layer wiring structure ML and the capacitor structure CS, and the first bonding insulating layer BD1 may surround the first bonding pads BP1. Accordingly, the first semiconductor structure S1 may be manufactured.

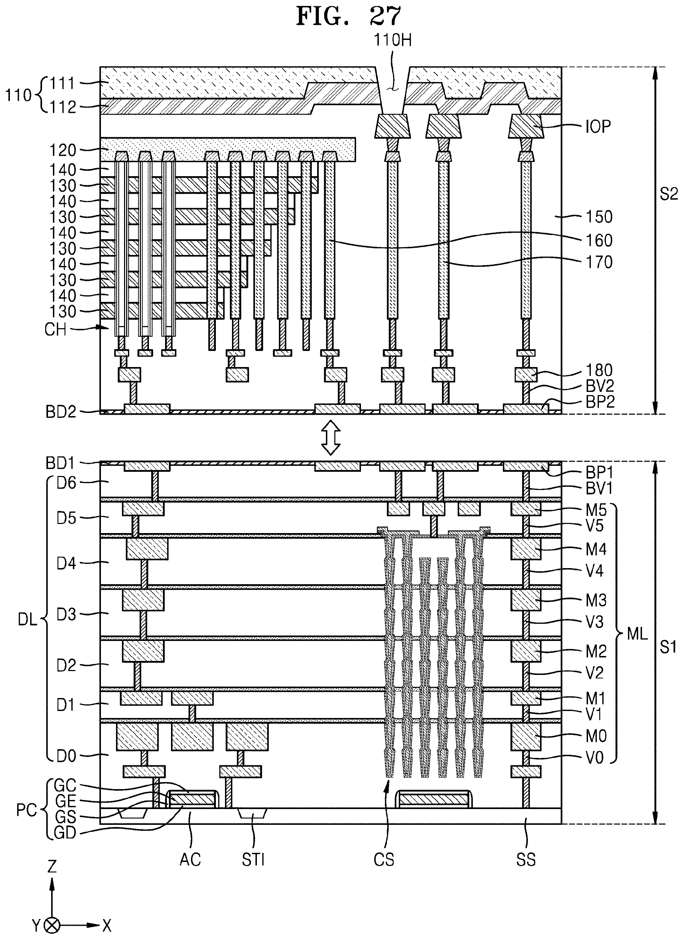

Referring to FIG. 27, the second semiconductor structure S2 may be disposed on the resulting structure of FIG. 26.

The details of the second semiconductor structure S2 are substantially the same as those described above, and thus, detailed descriptions thereof are omitted herein.

The first bonding pads BP1 of the first semiconductor structure S1 may be respectively aligned with the second bonding pads BP2 of the second semiconductor structure S2 in the vertical direction Z.

Next, the first semiconductor structure S1 may be brought into contact with and directly bonded to the second semiconductor structure S2 by hybrid bonding. Accordingly, the semiconductor device 100 (see FIG. 5) according to the inventive concept may be manufactured.

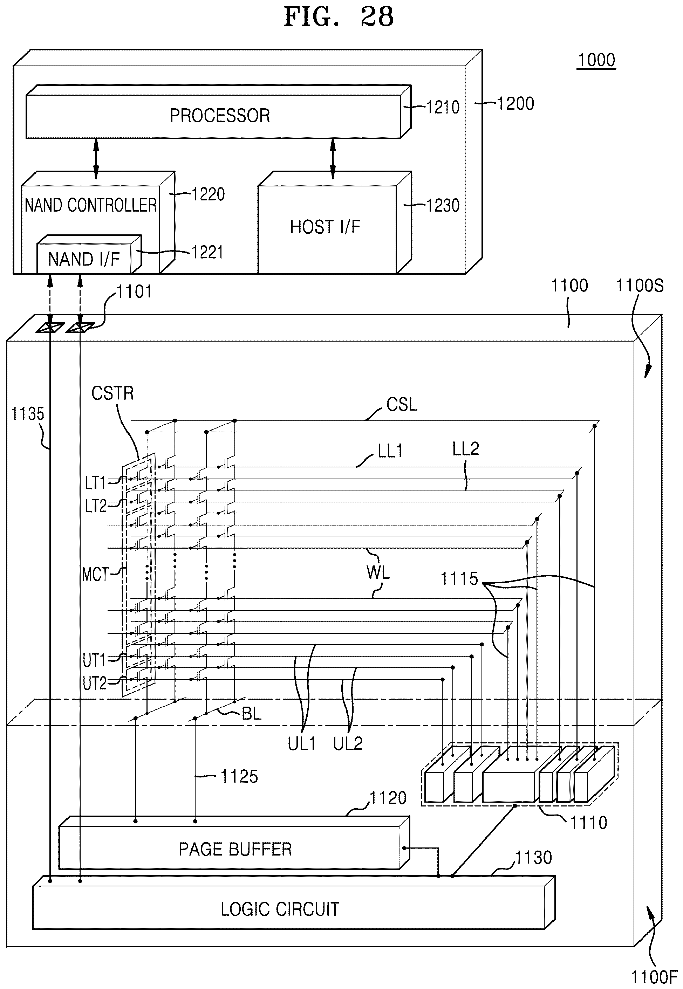

FIG. 28 is a diagram illustrating a data storage system 1000 including a semiconductor device according to an embodiment.

Referring to FIG. 28, the data storage system 1000 according to the inventive concept may include a semiconductor device 1100 and a controller 1200 electrically connected to the semiconductor device 1100.

The data storage system 1000 may represent a storage device including the semiconductor device 1100 or an electronic device including the storage device. For example, the data storage system 1000 may include a solid state drive (SSD) device, a universal serial bus (USB), a computing system, a medical device, or a communication device, which includes at least one semiconductor device 1100.

The semiconductor device 1100 may include a non-volatile vertical memory device. For example, the semiconductor device 1100 may represent a NAND flash memory device including at least one of the semiconductor devices 100, 100A, 100B, and 100C described above with reference to FIGS. 1 through 15. The semiconductor device 1100 may include a first structure 1100F and a second structure 1100S on the first structure 1100F. In some embodiments, the first structure 1100F may be located next to the second structure 1100S. The first structure 1100F may represent a peripheral circuit structure which includes a decoder circuit 1110, a page buffer 1120, and a logic circuit 1130. The second structure 1100S may include a memory cell structure which includes a bit line BL, a common source line CSL, a plurality of word lines WL, first and second gate upper lines UL1 and UL2, first and second gate lower lines LL1 and LL2, and a plurality of memory cell strings CSTR arranged between the bit line BL and the common source line CSL.

In the second structure 1100S, each of the plurality of memory cell strings CSTR may include lower transistors LT1 and LT2 adjacent to the common source line CSL, upper transistors UT1 and UT2 adjacent to the bit line BL, and a plurality of memory cell transistors MCT arranged between the lower transistors LT1 and LT2 and the upper transistors UT1 and UT2. The number of lower transistors LT1 and LT2 and the number of upper transistors UT1 and UT2 may be variously modified according to embodiments.

In some embodiments, the upper transistors UT1 and UT2 may include string selection transistors, and the lower transistors LT1 and LT2 may include ground selection transistors. A plurality of gate lower lines LL1 and LL2 may include gate electrodes of the lower transistors LT1 and LT2, respectively. The word lines WL may include gate electrodes of the memory cell transistors MCT, and gate upper lines UL1 and UL2 may include gate electrodes of the upper transistors UT1 and UT2.

The common source line CSL, the plurality of gate lower lines LL1 and LL2, the plurality of word lines WL, and the plurality of gate upper lines UL1 and UL2 may be electrically connected to the decoder circuit 1110 via the plurality of first connection wires 1115 that are provided inside the first structure 1100F and extend to the second structure 1100S. A plurality of bit lines BL may be electrically connected to the page buffer 1120 via a plurality of second connection wires 1125 that are provided inside the first structure 1100F and extend to the second structure 1100S.

In the first structure 1100F, the decoder circuit 1110 and the page buffer 1120 may execute a control operation on at least one of the plurality of memory cell transistors MCT. The decoder circuit 1110 and the page buffer 1120 may be controlled by the logic circuit 1130.

The semiconductor device 1100 may communicate with the controller 1200 via an input/output pad 1101 electrically connected to the logic circuit 1130. The input/output pad 1101 may be electrically connected to the logic circuit 1130 via an input/output connection wire 1135 that is provided inside the first structure 1100F and extends to the second structure 1100S.

The controller 1200 may include a processor 1210, a NAND controller 1220, and a host interface 1230. In some embodiments, the data storage system 1000 may include a plurality of semiconductor devices 1100. In this case, the controller 1200 may control the plurality of semiconductor devices 1100.

The processor 1210 may control all operations of the data storage system 1000 including the controller 1200. The processor 1210 may operate according to certain firmware and may access the semiconductor device 1100 by controlling the NAND controller 1220. The NAND controller 1220 may include a NAND interface 1221 that processes communication with the semiconductor device 1100. A control command for controlling the semiconductor device 1100, data to be written on the plurality of memory cell transistors MCT of the semiconductor device 1100, and data to be read from the plurality of memory cell transistors MCT of the semiconductor device 1100 may be transmitted via the NAND interface 1221. The host interface 1230 may provide a communication function between the data storage system 1000 and an external host. When a control command is received from the external host via the host interface 1230, the processor 1210 may control the semiconductor device 1100 in response to the control command.

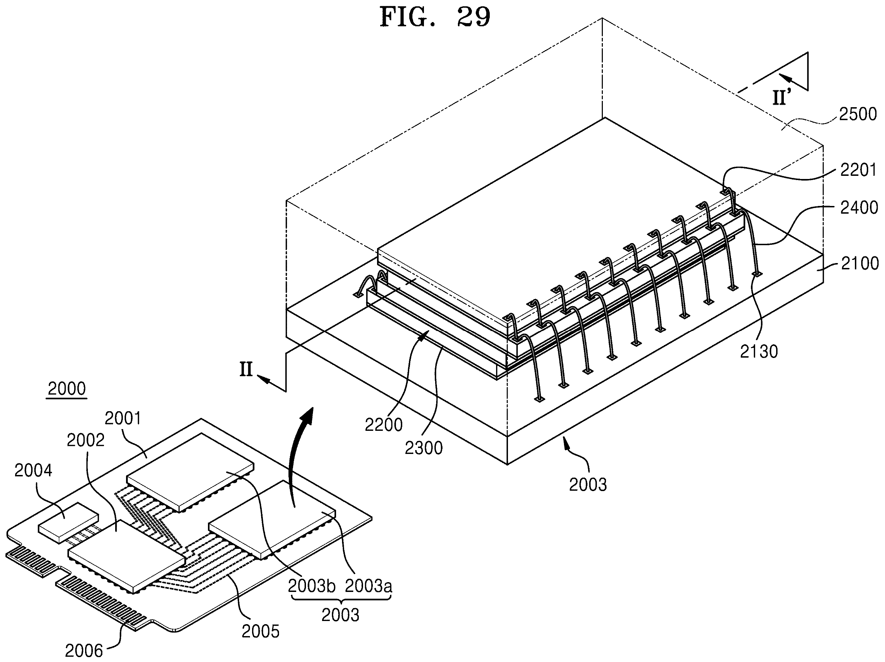

FIG. 29 is a perspective view showing a data storage system 2000 including a semiconductor device according to an embodiment.

Referring to FIG. 29, the data storage system 2000 according to an embodiment may include a main board 2001, a controller 2002 mounted on the main board 2001, one or more semiconductor packages 2003, and dynamic random-access memory (DRAM) 2004. The semiconductor package 2003 and the DRAM 2004 may be connected to the controller 2002 by a plurality of wiring patterns 2005 formed on the main board 2001.

The main board 2001 may include a connector 2006 including a plurality of pins coupled to an external host. The number and arrangement of the plurality of pins in the connector 2006 may vary depending on the communication interface between the data storage system 2000 and the external host. In some embodiments, the data storage system 2000 may communicate with the external host according to any one of interfaces, such as a USB, peripheral components interconnect express (PCI-Express), serial advanced technology attachment (SATA), and M-Phy for universal flash storage (UFS). In some embodiments, the data storage system 2000 may be operated by power supplied from the external host via the connector 2006. The data storage system 2000 may further include a power management integrated circuit (PMIC) that distributes the power, supplied from the external host, to the controller 2002 and the semiconductor package 2003.

The controller 2002 may write data on the semiconductor package 2003 or read data from the semiconductor package 2003 and may improve the operating speed of the data storage system 2000.

The DRAM 2004 may include a buffer memory for reducing a difference in speeds between the external host and the semiconductor package 2003 that includes a data storage space. The DRAM 2004 in the data storage system 2000 may also operate as a cache memory and may provide a space for temporarily storing data during the operation of controlling the semiconductor package 2003. When the data storage system 2000 includes the DRAM 2004, the controller 2002 may further include a DRAM controller for controlling the DRAM 2004 in addition to a NAND controller for controlling the semiconductor package 2003.

The semiconductor package 2003 may include first and second semiconductor packages 2003a and 2003b spaced apart from each other. The first and second semiconductor packages 2003a and 2003b each may include a plurality of semiconductor chips 2200. Each of the first and second semiconductor packages 2003a and 2003b may include a package board 2100, a plurality of semiconductor chips 2200 on the package board 2100, an adhesive layer 2300 disposed on the lower surface of each of the plurality of semiconductor chips 2200, a connection structure 2400 electrically connecting the plurality of semiconductor chips 2200 to the package board 2100, and a molding layer 2500 covering the plurality of semiconductor chips 2200 and the connection structure 2400 on the package board 2100.

The package board 2100 may include a printed circuit board including a plurality of package upper pads 2130. Each of the plurality of semiconductor chips 2200 may include an input/output pad 2201. The input/output pad 2201 may correspond to the input/output pad 1101 (see FIG. 28). Each of the plurality of semiconductor chips 2200 may include at least one of the semiconductor devices 100, 100A, 100B, and 100C described above with reference to FIGS. 1 through 15.

In embodiments, the connection structure 2400 may include bonding wires electrically connecting input/output pads 2201 to the package upper pads 2130. Accordingly, in the first and second semiconductor packages 2003a and 2003b, the plurality of semiconductor chips 2200 may be electrically connected to each other by using a bonding wire method and may be electrically connected to the package upper pads 2130 of the package board 2100. In some embodiments, in the first and second semiconductor packages 2003a and 2003b, the plurality of semiconductor chips 2200 may be electrically connected to each other by a connection structure including a through silicon via (TSV), instead of using the connection structure 2400 in the bonding wire method.

In some embodiments, the controller 2002 and the plurality of semiconductor chips 2200 may be included in a single package. In some embodiments, the controller 2002 and the plurality of semiconductor chips 2200 may be mounted on a separate interposer board different from the main board 2001, and the controller 2002 and the plurality of semiconductor chips 2200 may be connected to each other by means of a wire formed on the interposer board.

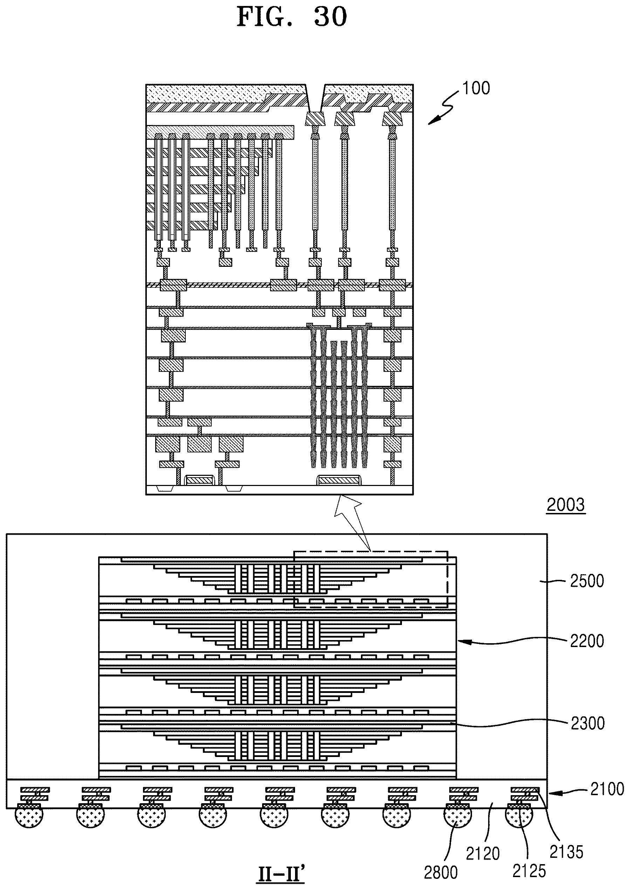

FIG. 30 is a cross-sectional view showing a semiconductor package 2003 including a semiconductor device according to an embodiment.

Referring to FIG. 30, in the semiconductor package 2003, the package board 2100 may include a printed circuit board.

The package board 2100 may include a body 2120, the package upper pads 2130 (see FIG. 29) disposed on the upper surface of the body 2120, package lower pads 2125 disposed on the lower surface of the body 2120 or exposed at the lower surface of the body 2120, and inner wires 2135 provided inside the body 2120 and electrically connecting the package upper pads 2130 (see FIG. 29) to the package lower pads 2125.

The plurality of lower pads 2125 may be connected to the plurality of wiring patterns 2005 on the main board 2001 (see FIG. 29) via the plurality of conductive bumps 2800. Each of the plurality of semiconductor chips 2200 may include at least one of the semiconductor devices 100, 100A, 100B, and 100C described above with reference to FIGS. 1 through 15.

Embodiments are set out in the following Clauses:
Clause 1. A semiconductor device comprising:
   a substrate having an active region defined by a device isolation region;
   a peripheral circuit device on the active region;
   a multi-layer wiring structure comprising a plurality of wiring layers connected to the peripheral circuit device and a plurality of via layers connecting the plurality of wiring layers to each other in a vertical direction;
   a multi-layer insulating structure comprising a plurality of insulating layers surrounding the plurality of wiring layers and the plurality of via layers;
   a recess region comprising a plurality of recess patterns spaced apart from the multi-layer wiring structure in a horizontal direction and at least partially extending through the multi-layer insulating structure;
   a first electrode layer conformally arranged along inner walls of the plurality of recess patterns and an upper surface of the multi-layer insulating structure;
   a capacitor dielectric layer conformally arranged along an inner wall and an upper surface of the first electrode layer;
   a second electrode layer in contact with an inner wall and an upper surface of the capacitor dielectric layer and filling the plurality of recess patterns;
   a first routing via in contact with the upper surface of the first electrode layer; and
   a second routing via in contact with an upper surface of the second electrode layer,
   wherein a sidewall of the first electrode layer located in each of the plurality of recess patterns has a plurality of curved sections in the vertical direction.
Clause 2. The semiconductor device of Clause 1, wherein vertical levels of the plurality of curved sections are substantially same as vertical levels of bonding interfaces between the plurality of wiring layers and the plurality of via layers, and
   the capacitor dielectric layer has a concave-convex shape corresponding to the plurality of curved sections.
Clause 3. The semiconductor device of Clause 1 or Clause 2, wherein an uppermost end of the first routing via is positioned at substantially a same vertical level as an uppermost end of the second routing via, and
   a lowermost end of the first routing via is positioned at a lower vertical level than a lowermost end of the second routing via.
Clause 4. The semiconductor device of any of Clauses 1-3, wherein the first electrode layer extends as a single conductive layer along the plurality of recess patterns.
Clause 5. The semiconductor device of Clause 4, wherein the first electrode layer extends through an upper part of the device isolation region.

While the inventive concept has been particularly shown and described with reference to embodiments thereof, it will be understood that various changes in form and details may be made therein without departing from the scope of the following claims.

## Claims

1. A semiconductor device comprising:
a peripheral circuit structure (PERI) comprising a substrate (SS) having an active region (AC) defined by a device isolation region (STI), a peripheral circuit device (PC) on the active region (AC), a multi-layer wiring structure (ML) connected to the peripheral circuit device (PC), a multi-layer insulating structure (DL) surrounding the multi-layer wiring structure (ML), a capacitor structure (CS) spaced apart from the multi-layer wiring structure (ML) in a horizontal direction and at least partially extending through the multi-layer insulating structure (DL), and first bonding pads (BP1) connected to the multi-layer wiring structure (ML) and the capacitor structure (CS); and
a memory cell structure (CELL) comprising a passivation layer (110) having a cell region (R1) and a pad region (R2), gate electrodes (130) stacked in the cell region (R1) and spaced apart from each other in a vertical direction, a channel structure (CH) extending through the gate electrodes (130), an input/output pad (IOP) located in the pad region (R2), a cover insulating layer (150) covering the cell region (R1) and the pad region (R2), a through-plug (170) extending through the cover insulating layer (150) in the pad region (R2) and connected to the input/output pad (IOP), a cell wiring structure (180) connected to the channel structure (CH) and the through-plug (170), and second bonding pads (BP2) connected to the cell wiring structure (180),
wherein the capacitor structure (CS) comprises a first electrode layer (EL1) conformally formed on an inner wall of a recess region (RA) at least partially extending through the multi-layer insulating structure (DL), a capacitor dielectric layer (CDL) conformally formed on an inner wall of the first electrode layer (EL1), and a second electrode layer (EL2) in contact with an inner wall of the capacitor dielectric layer (CDL) and filling the recess region (RA), and
at least a part of a first routing via (RV1), which is in contact with an upper surface of the first electrode layer (EL1), is positioned at substantially a same vertical level as at least a part of a second routing via (RV2) in contact with an upper surface of the second electrode layer (EL2).

2. The semiconductor device of claim 1, wherein the memory cell structure (CELL) is stacked on the peripheral circuit structure (PERI), and
the first bonding pads (BP1) are respectively bonded to the second bonding pads (BP2).

3. The semiconductor device of claim 2, wherein the capacitor structure (CS) overlaps the pad region (R2) in the vertical direction, while being offset from the cell region (R1) in the vertical direction.

4. The semiconductor device of claim 3, wherein the first and second routing vias (RV1, RV2) each are electrically connected to the input/output pad (IOP) via one of the first bonding pads (BP1), one of the second bonding pads (BP2), and the through-plug (170).

5. The semiconductor device of any preceding claim, wherein the recess region (RA) comprises a plurality of recess patterns (RP) extending in the vertical direction and spaced apart from each other in the horizontal direction, and
the first electrode layer (EL1), the capacitor dielectric layer (CDL), and the second electrode layer (EL2) fill the plurality of recess patterns (RP) and extend in the horizontal direction.

6. The semiconductor device of claim 5, wherein the first electrode layer (EL1), the capacitor dielectric layer (CDL), and the second electrode layer (EL2) extend through interlayer interfaces of a plurality of insulating layers (D0-D4) of the multi-layer insulating structure (DL) and extend lengthwise in the vertical direction.

7. The semiconductor device of claim 6, wherein a sidewall of the first electrode layer (EL1) located in each of the plurality of recess patterns (RP) has a plurality of curved sections (CV) in the vertical direction.

8. The semiconductor device of claim 7 wherein vertical levels of the plurality of curved sections (CV) are substantially same as vertical levels of bonding interfaces (IF) of a plurality of wiring layers (M0-M5) of the multi-layer wiring structure (ML).

9. The semiconductor device of claim 7 or claim 8, wherein the capacitor dielectric layer (CDL) has a concave-convex shape corresponding to the plurality of curved sections (CV).

10. The semiconductor device of any preceding claim, wherein a lowermost end of the first routing via (RV1) is positioned at a lower vertical level than a lowermost end of the second routing via (RV2).

11. The semiconductor device of claim 10, wherein uppermost ends of portions of the second electrode layer (EL2) located below the first routing via (RV1) are positioned at lower vertical levels than uppermost ends of other parts of the second electrode layer (EL2).

12. The semiconductor device of any preceding claim, wherein:
the multi-layer wiring structure (ML) comprises a plurality of wiring layers (M0-M5) connected to the peripheral circuit device (PERI) and a plurality of via layers (V0-V5) connecting the plurality of wiring layers (M0-M5) to each other in the vertical direction; and
the multi-layer insulating structure (DL) comprises a plurality of insulating layers (D0-D5) surrounding the plurality of wiring layers (M0-M5) and the plurality of via layers (V0-V5).

13. The semiconductor device of any preceding claim, wherein an uppermost end of the first routing via (RV1) is positioned at substantially a same vertical level as an uppermost end of the second routing via (RV2).

14. The semiconductor device of any of preceding claim, wherein:
the first electrode layer (EL1) extends as a single conductive layer along the plurality of recess patterns (RP); and/or
the first electrode layer (EL1) is arranged on an upper surface of the multi-layer insulating structure (ML).

15. The semiconductor device of any preceding claim, wherein the first electrode layer (EL1) extends through an upper part of the device isolation region (STI).
